(19) **Europäisches Patentamt / European Patent Office / Office européen des brevets**

(11) **EP 3 578 937 A1**

(12) **EUROPEAN PATENT APPLICATION**
published in accordance with Art. 153(4) EPC

(43) Date of publication:
**11.12.2019 Bulletin 2019/50**

(21) Application number: **18748413.4**

(22) Date of filing: **30.01.2018**

(51) Int Cl.:
*G01J 1/02* (2006.01)          *G02B 6/42* (2006.01)
*H01L 31/0232* (2014.01)

(86) International application number:
**PCT/JP2018/002931**

(87) International publication number:
**WO 2018/143181 (09.08.2018 Gazette 2018/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **02.02.2017   JP 2017017430**
**02.02.2017   JP 2017017476**
**02.02.2017   JP 2017017477**

(71) Applicant: **Fujikura Ltd.**
**Tokyo 135-8512 (JP)**

(72) Inventors:
• **YAMAUCHI Takanori**
  **Sakura-shi**
  **Chiba 285-8550 (JP)**
• **KIYOYAMA Wataru**
  **Sakura-shi**
  **Chiba 285-8550 (JP)**
• **SAKAMOTO Shinichi**
  **Sakura-shi**
  **Chiba 285-8550 (JP)**
• **TAKAHASHI Akari**
  **Sakura-shi**
  **Chiba 285-8550 (JP)**

(74) Representative: **Plasseraud IP**
**66, rue de la Chaussée d'Antin**
**75440 Paris Cedex 09 (FR)**

(54) **PHOTODETECTOR AND METHOD FOR MANUFACTURING PHOTODETECTOR**

(57)     A photodetector includes a substrate, an optical fiber placed on the substrate; and a photodetection element that is fixed to the substrate, and is configured to detect scattered light of light guided by the optical fiber.

FIG. 2

**Description**

Technical Field

The present invention relates to a photodetector and a method for manufacturing a photodetector.
Priority is claimed on Japanese Patent Application Nos. 2017-017430, 2017-017476, and 2017-017477, filed on February 2, 2017, the contents of which are incorporated herein by reference.

Background Art

In the related art, a photodetector as disclosed in Patent Document 1 has been known. The photodetector includes a photodetection element that detects scattered light of light guided by an optical fiber.
In this type of photodetector, since the detection result of the scattered light changes depending on the relative positions of the photodetection element and the optical fiber, it is necessary to fix the photodetection element and the optical fiber by a fixing member or the like.

Citation List

Patent Literature

[Patent Document 1] Published Japanese Translation No. 2013-508688

Summary of Invention

Technical Problem

Meanwhile, when the temperature of the fixing member changes due to a change in ambient temperature or the like, the fixing member may expand or contract, which may cause a shift in the relative positions of the photodetection element and the optical fiber. As a result, the detection result of the scattered light changes with the temperature change of the fixing member.
The present invention has been made in view of such circumstances, and an object of the present invention is to provide a photodetector capable of limiting relative positional deviation between a photodetection element and an optical fiber caused by a temperature change.

Solution to Problem

In order to solve the above problems, a photodetector according to a first aspect of the present invention includes a substrate, an optical fiber placed on the substrate; and a photodetection element that is fixed to the substrate, and is configured to detect scattered light of light guided by the optical fiber.
In a photodetector according to a second aspect of the present invention, the photodetector according to the first aspect may further include a first fixing member and a second fixing member that fix the optical fiber to the substrate, in which the first fixing member is disposed on an opposite side of the photodetection element from the second fixing member in a longitudinal direction in which the optical fiber extends, when a volume of a portion of the first fixing member on a first side across the optical fiber in a transverse direction orthogonal to the longitudinal direction is $V_1$ and a volume of a portion of the first fixing member on a second side opposite to the first side is $V_2$, in top view, and a volume of a portion of the second fixing member on the first side of the optical fiber in the transverse direction is $V_3$, and a volume of a portion of the second fixing member on the second side is $V_4$, in top view, either $V_1 > V_2$ and $V_3 < V_4$, or $V_1 < V_2$ and $V_3 > V_4$ is satisfied.
According to the second aspect, since the first fixing member and the second fixing member are configured to satisfy any one of $V_1 > V_2$ and $V_3 < V_4$ or $V_1 < V_2$ and $V_3 > V_4$, the optical fiber is rotationally moved relative to the photodetection element as the temperature changes. Thus, for example, as compared with the case where the photodetector is configured to satisfy $V_1 > V_2$ and $V_3 > V_4$, and the optical fiber moves in parallel with the photodetection element, it is possible to reduce the relative positional deviation between the optical fiber and the photodetection element due to the temperature change.
According to a photodetector of a third aspect of the present invention, in the photodetector according to the second aspect, when a linear expansion coefficient of a material forming the first fixing member is $\alpha_1$, and a linear expansion coefficient of a material forming the second fixing member is $\alpha_2$, and in top view, a distance between a center of gravity of the first fixing member and the optical fiber in the transverse direction is $X_1$, and a distance between a center of gravity of the second fixing member and the optical fiber in the transverse direction is $X_2$, $\alpha_1/\alpha_2 = X_2/X_1$ is satisfied.

According to the third aspect, since the optical fiber rotates around the vicinity of the photodetection element due to a temperature change, it is possible to more reliably reduce the relative positional deviation between the photodetection element and the optical fiber.

A method for manufacturing a photodetector according to a fourth aspect is a method for manufacturing a photodetector including a substrate, an optical fiber which is placed on the substrate, a photodetection element which is fixed to the substrate, and is configured to detect scattered light of light guided by the optical fiber, and a first fixing member and a second fixing member which fix the optical fiber to the substrate, the first fixing member being disposed on an opposite side of the photodetection element from the second fixing member in a longitudinal direction in which the optical fiber extends, the method including: a first application step of applying a resin to be the first fixing member to the substrate and the optical fiber; a volume detection step of detecting a volume $V_1$ of a portion of the first fixing member on a first side across the optical fiber in a transverse direction orthogonal to the longitudinal direction, and a volume $V_2$ of a portion of the first fixing member on a second side opposite to the first side, in top view; and a second application step of applying a resin to be the second fixing member to the substrate and the optical fiber, based on a detection result in the volume detection step, in which when, in top view, a volume of a portion of the second fixing member on the first side in the transverse direction is $V_3$, and a volume of a portion of the second fixing member on the second side is $V_4$, a discharge amount of the resin to be the second fixing member is controlled such that either $V_1 > V_2$ and $V_3 < V_4$ or $V_1 < V_2$ and $V_3 > V_4$ is satisfied, in the second application step.

According to the manufacturing method of the fourth aspect, since the resin to be the second fixing member is discharged based on the detection results of the volumes $V_1$, $V_2$ of the first fixing member, for example, in a case where the first fixing member is applied unevenly to the optical fiber in the transverse direction, the second fixing member is formed by controlling a discharge amount of the resin to be the second fixing member such that the relative positional deviation between the photodetection element and the optical fiber due to the temperature change.

A photodetector according to a fifth aspect of the present invention is the photodetector according to any one of the first to third aspects further including a first fixing member and a second fixing member which fix the optical fiber to the substrate, in which the first fixing member is disposed on an opposite side of the photodetection element from the second fixing member in a longitudinal direction in which the optical fiber extends, and the first fixing member is formed of a material having a positive linear expansion coefficient, and the second fixing member is formed of a material having a negative linear expansion coefficient.

According to the photodetector of the fifth aspect, the optical fiber is fixed to the substrate by the first fixing member and the second fixing member. Further, the first fixing member is formed of a material having a positive linear expansion coefficient, and the second fixing member is formed of a material having a negative linear expansion coefficient. Therefore, in a case where a temperature change occurs in the first fixing member and the second fixing member, one of the first fixing member and the second fixing member contracts, and the other expands. The first fixing member and the second fixing member are disposed on both sides of the photodetection element in the longitudinal direction of the optical fiber. Thus, for example, in a case where both the first fixing member and the second fixing member are formed of a material having a positive linear expansion coefficient, it is possible to limit the relative positional deviation between the optical fiber and the photodetection element caused by expansion of both the first fixing member and the second fixing member. Further, for example, in a case where both the first fixing member and the second fixing member are formed of a material having a negative linear expansion coefficient, it is possible to limit the application of tension to the optical fiber because both first fixing member and the second fixing member contract.

A photodetector according to a sixth aspect of the present invention is the photodetector according to the fifth aspect, in which the second fixing member is formed of a material having a negative linear expansion coefficient in the longitudinal direction.

A photodetector according to a seventh aspect of the present invention is the photodetector according to the fifth or sixth aspect, in which an absolute value of the linear expansion coefficient of the material forming the second fixing member is larger than an absolute value of the linear expansion coefficient of the material forming the first fixing member.

According to the seventh aspect, since the contraction amount of the second fixing member exceeds the expansion amount of the first fixing member when the temperature of the photodetector rises, it is possible to more reliably limit bending of the optical fiber, for example, in the vertical direction or the horizontal direction between the first fixing member and the second fixing member, and a change in the position with respect to the photodetection element.

A photodetector according to an eighth aspect of the present invention is the photodetector according to any one of the fifth to seventh aspects, in which when the linear expansion coefficient of a material forming the first fixing member is $\alpha_A$, and the absolute value of a linear expansion coefficient of a material forming the second fixing member is $\alpha_B$, and the distance between the center of gravity of the first fixing member and the optical fiber is $X_{0A}$, and the distance between the center of gravity of the second fixing member and the optical fiber is $X_{0B}$, the value of $\alpha_A/\alpha_B$ and the value of $X_{0B}/X_{0A}$ are approximately the same.

According to the eighth aspect, in a case where the optical fiber is disposed out of the ideal design position, the optical fiber moves so as to rotate around the vicinity of the photodetection element as the temperature changes. Therefore, the amount of change in the distance of the optical fiber to the photodetection element depending on the temperature can be further reduced. Thereby, the temperature dependency of the detection result by the photodetection element can be further reduced.

A photodetector according to a ninth aspect of the present invention is the photodetector according to any one of the first to third aspects and the fifth to eighth aspects further including a first fixing member and a second fixing member which fix the optical fiber to the substrate; and a fixing base which fixes the photodetection element to the substrate, in which the fixing base has at least one opening, a portion of the optical fiber is accommodated inside the fixing base through the opening, and the at least one opening is closed by either the first fixing member or the second fixing member.

According to the ninth aspect, the opening for introducing the optical fiber to the inside of the fixing base is closed by the fixing member. Therefore, it is possible to prevent dust or the like from entering the fixing base through an opening and affecting the detection result of the scattered light by the photodetection element.

A photodetector according to a tenth aspect of the present invention is the photodetector according to the ninth aspect in which a part of either the first fixing member or the second fixing member is located inside the fixing base.

According to the tenth aspect, the effect of fixing the optical fiber to the substrate by the first fixing member or the second fixing member can be further enhanced. Further, it is possible to prevent dust or the like from entering a space where the light receiving surface of the photodetection element and the optical fiber face each other. Then, the detection result of the scattered light by the photodetection element can be further stabilized.

A photodetector according to an eleventh aspect of the present invention is the photodetector according to the ninth or tenth aspect in which the fixing base has a main body that holds the photodetection element, and a width of either the first fixing member or the second fixing member is larger than a width of the main body.

According to the eleventh aspect, the contact area of the first fixing member or the second fixing member and the substrate is increased. Therefore, the connection strength between the first fixing member or the second fixing member and the substrate increases, and the optical fiber can be fixed to the substrate more securely.

A photodetector according to a twelfth aspect of the present invention is the photodetector according to the ninth or tenth aspect in which the fixing base has a main body that holds the photodetection element, and a width of either the first fixing member or the second fixing member is smaller than a width of the main body.

According to the twelfth aspect, the area of the portion of the substrate covered by the first fixing member or the second fixing member is reduced. Therefore, since the area of the substrate on which other components can be mounted increases, the mounting density of components can be raised.

A photodetector according to a thirteenth aspect of the present invention is the photodetector according to any one of the first to third or the fifth to twelfth aspects further including: a connection member which is fixed to the substrate in contact with a mounting surface of the substrate, has a placing surface on which the optical fiber is placed, and connects the optical fiber located on the placing surface and the substrate; a photodetection element that detects scattered light of light guided by the optical fiber; and a fixing base which fixes the photodetection element to the substrate, and expands and contracts at least in a vertical direction with a temperature change, in which the fixing base has at least one opening, and a contact surface fixed in contact with the mounting surface, a portion of the optical fiber is accommodated inside the fixing base through the opening, the placing surface is positioned at least a portion facing the photodetection element across at least the optical fiber, and the connection member expands and contracts at least in the vertical direction with a temperature change such that the distance in the vertical direction between the optical fiber located on the placing surface and the photodetection element is within a predetermined range.

According to the photodetector in the thirteenth aspect, the photodetection element is fixed to the substrate through the fixing base, and is fixed in a state where the contact surface of the fixing base is in contact with the mounting surface of the substrate. Therefore, when the temperature of the photodetector rises or falls, the fixing base thermally expands or thermally contracts. Therefore, the photodetection element moves in the vertical direction with respect to the mounting surface of the substrate.

On the other hand, the optical fiber is placed on the placing surface of the connection member, and the connection member is fixed in contact with the mounting surface of the substrate and connects the optical fiber located on the placing surface and the substrate. Further, the placing surface is disposed at a portion facing at least the photodetection element with at least the optical fiber interposed therebetween. Then, the connection member expands and contracts at least in the vertical direction with the temperature change such that the distance in the vertical direction between the optical fiber placed on the placing surface and the photodetection element is within a predetermined range. Thus, as compared with, for example, a case where the optical fiber is directly placed on the mounting surface of the substrate, it is possible to limit the relative positional deviation between the photodetection element and the optical fiber in the vertical direction caused by the temperature change.

A photodetector according to a fourteenth aspect of the present invention is the photodetector according to the thirteenth aspect, in which the fixing base has a positioning unit which determines a position of the photodetection element in the vertical direction with respect to the mounting surface, a linear expansion coefficient of a material forming the connection member is $\alpha_a$, a linear expansion coefficient of a material forming the fixing base is $\alpha_b$, a thickness in the vertical direction of a portion of the connection member on which the optical fiber is placed is $H_{a0}$, and a length in the vertical direction from the contact surface to the positioning portion is $H_{b0}$, $\alpha_a \times H_{a0}(\alpha_a \times H_{a0} - 2 \times \alpha_b \times H_{b0}) < 0$ is satisfied.

According to the fourteenth aspect, the connection member and the fixing base are configured to satisfy $\alpha_a \times H_{a0}(\alpha_a \times H_{a0} - 2 \times \alpha_b \times H_{b0}) < 0$. Thus, since the thermal expansion amount or thermal contraction amount of the connection member excessively exceeds the thermal expansion amount or thermal contraction amount of the fixing base, and the connection member is provided, it is possible to limit an increase in relative positional deviation in the vertical direction caused by the temperature change of the photodetection element and optical fiber, and to more reliably achieve the above-described effects of the photodetector.

A photodetector according to a fifteenth aspect of the present invention is the photodetector according to the fourteenth aspect, in which a value of $\alpha_b \times H_{b0}$ and a value of $\alpha_a \times H_{a0}$ are substantially the same.

According to the fifteenth aspect, the amount of movement of the photodetection element in the vertical direction with respect to the mounting surface of the substrate due to thermal expansion or thermal contraction of the fixing base and the amount of movement of the optical fiber in the vertical direction with respect to the mounting surface of the substrate due to thermal expansion or thermal contraction of the connection member are substantially the same. Thus, even if a temperature change occurs, the photodetection element and the optical fiber are displaced while maintaining the relative positional relationship in the vertical direction, and it is possible to more reliably limit the relative positional deviation in the vertical direction of the both caused by the temperature change.

Advantageous Effects of Invention

According to the above aspects of the present invention, it is possible to provide a photodetector capable of limiting relative positional deviation between a photodetection element and an optical fiber caused by a temperature change.

Brief Description of Drawings

FIG. 1 is a block diagram showing a configuration of a laser system provided with a photodetector of a first embodiment.
FIG. 2 is a perspective view of the photodetector of the first embodiment.
FIG. 3 is a top view of the photodetector of the first embodiment.
FIG. 4 is a cross-sectional view of the photodetector taken along line A-A in FIG. 3.
FIG. 5 is a cross-sectional view of the photodetector taken along line B-B in FIG. 3.
FIG. 6A is a top view showing a photodetector of a comparative example in which a first fixing member and a second fixing member are formed to be biased to the -X side, and shows a state before a temperature change.
FIG. 6B is a view showing the state of FIG. 6A after the temperature change.
FIG. 7A is a top view of the photodetector of the present embodiment, showing a state before a temperature change.
FIG. 7B is a view showing a state of FIG. 7A after the temperature change.
FIG. 8 is a top view of the photodetector of the first embodiment.
FIG. 9 is a block diagram showing a configuration of a laser system provided with a photodetector of a second embodiment.
FIG. 10 is a perspective view of the photodetector of the second embodiment.
FIG. 11 is a top view of the photodetector of the second embodiment.
FIG. 12 is a cross-sectional view of the photodetector taken along line A-A in FIG. 11.
FIG. 13 is a cross-sectional view of the photodetector taken along line B-B in FIG. 11.
FIG. 14A is an explanatory diagram of a case where a temperature of the photodetector of the comparative example rises.
FIG. 14B is an explanatory diagram of a case where a temperature of the photodetector of the second embodiment rises.
FIG. 15A is a top view showing a state in which the position of the optical fiber is shifted in the photodetector shown in FIG. 11, and shows a state before a temperature change.
FIG. 15B is a view showing a state of FIG. 15A after the temperature change.
FIG. 16 is a block diagram showing a configuration of a laser system provided with a photodetector of a third embodiment.

FIG. 17 is a perspective view of the photodetector of the third embodiment.

FIG. 18 is a top view of the photodetector of the third embodiment.

FIG. 19 is a cross-sectional view of the photodetector taken along line A-A in FIG. 18.

FIG. 20 is a cross-sectional view of the photodetector taken along line B-B in FIG. 18.

FIG. 21 is a graph showing a fluctuation of a detection value by the photodetection element according to the temperature.


Description of Embodiments

(First Embodiment)

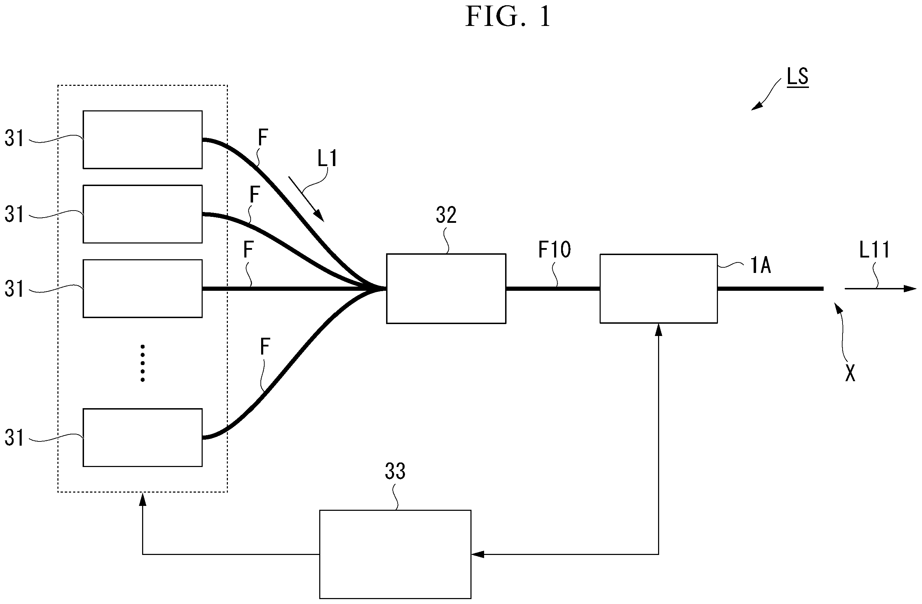

The configuration of a photodetector according to a first embodiment will be described below with reference to FIGS. 1 to 8

In order to facilitate understanding of the invention, in FIGS. 1 to 8, the scales of components are appropriately changed.

FIG. 1 is a block diagram showing the configuration of a laser system provided with a photodetector 1A of the present embodiment.

As shown in FIG. 1, a laser system LS includes a plurality of laser devices 31, a combiner 32 (multiplexer), an optical fiber F10 (output optical fiber), a photodetector 1A, and a control device 33 (control unit). The laser system LS outputs output light L11 (laser light) from the output end X of the optical fiber F10.

The laser device 31 is a device that outputs a laser beam under the control of the control device 33.

The combiner 32 optically combines the plurality of beams of output light L1 output from the plurality of laser devices 31. Inside the combiner 32, the optical fibers F extending from respective laser devices 31 are bundled into one (made into one by melt drawing), and the one optical fiber is fusion-spliced to one end of the optical fiber F10. The optical fiber F10 is an optical fiber functioning as a transmission medium, and guides the output light L11 (light obtained by optically combining a plurality of beams of output light L1 output from the laser devices 31 by the combiner 32). The output light L11 guided by the optical fiber F10 is output from the output end X of the optical fiber F10.

The control device 33 controls the plurality of laser devices 31 such that the power of the output light L11 output from the output end X becomes constant, based on the detection result to be described later of the photodetector 1A to be described later.

The photodetector 1A is disposed between the combiner 32 and the output end X, and is configured to detect the power of light guided by the optical fiber F10. The photodetector 1A may be disposed between the laser device 31 and the combiner 32, and may detect the power of light guided by the optical fiber F.

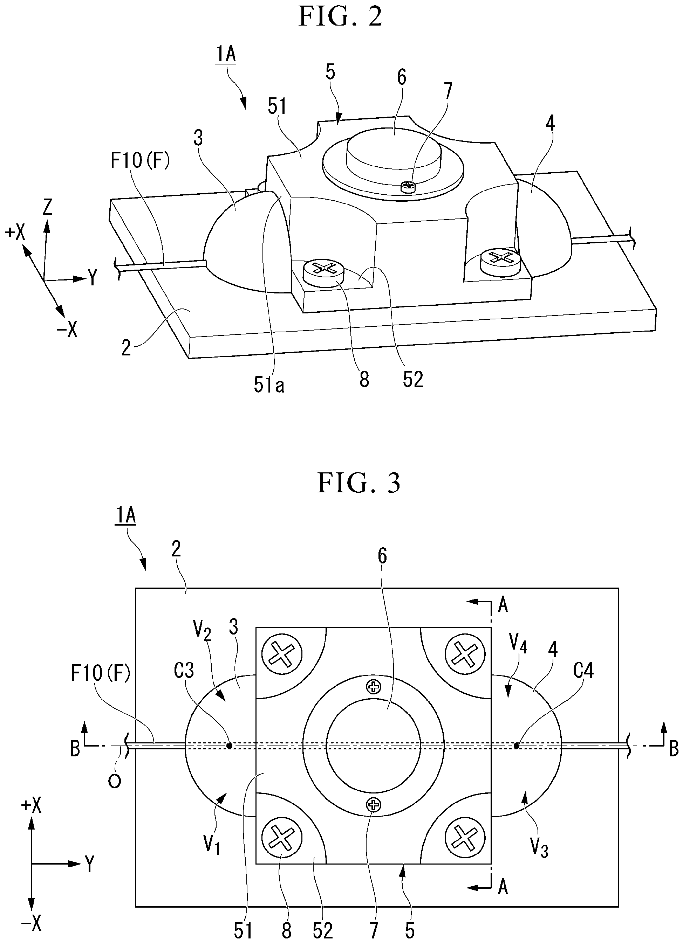

FIG. 2 is a perspective view of the photodetector 1A. As shown in FIG. 2, the photodetector 1A includes a substrate 2, an optical fiber F10 or an optical fiber F (hereinafter simply referred to as an optical fiber F10) placed on the substrate 2, a first fixing member 3, a second fixing member 4, a fixing base 5, and a photodetection element 6.

Here, in the present embodiment, an XYZ orthogonal coordinate system is set, and the positional relationship of each configuration will be described. A Y direction is the extending direction (longitudinal direction) of the optical fiber F10 in a state before the optical fiber F10 moves due to a temperature change. A Z direction is a direction (vertical direction) perpendicular to the surface of the substrate 2 on which the optical fiber F10 is placed. In the Z direction, the side of the substrate 2 on which the optical fiber F10 is placed is referred to as the upper side, and the opposite side is referred to as the lower side. A X direction (transverse direction) is a direction orthogonal to both the Y direction and the Z direction.

Further, in top view (plan view), a first side of the optical fiber F10 in the X direction may be referred to as the -X side, and a second side may be referred to as the + X side.

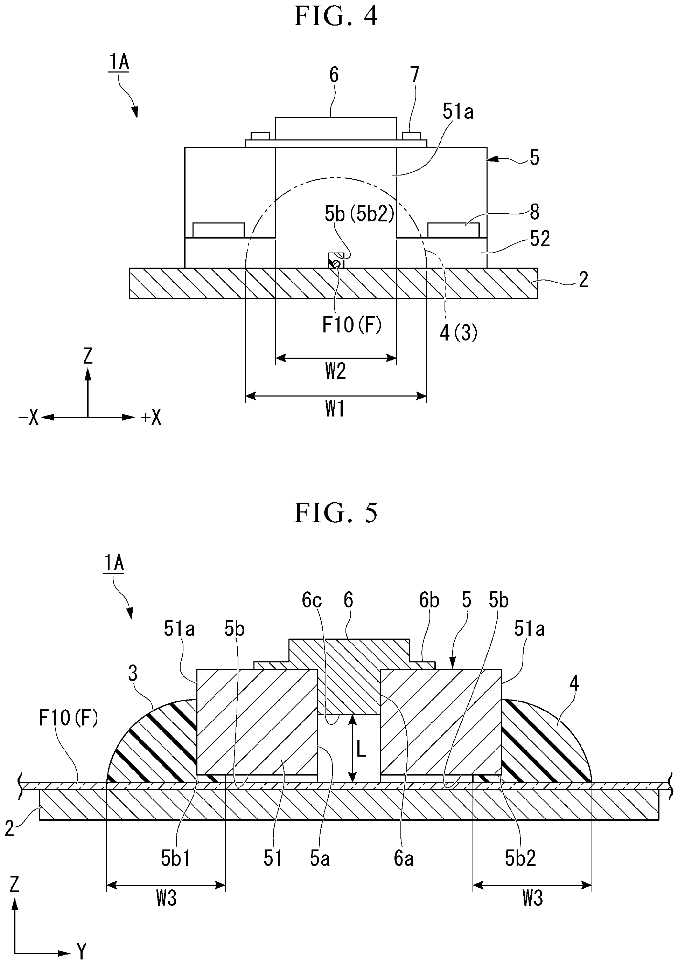

FIG. 3 is a top view of the photodetector 1A. FIG. 4 is a cross-sectional view taken along line A-A in FIG. 3, and the outline of the second fixing member 4 is indicated by a two-dot chain line. FIG. 5 is a cross-sectional view taken along line B-B in FIG. 3.

As shown in FIG. 2 and the like, the fixing base 5 has a main body 51 that holds the photodetection element 6 and a fastening portion 52 for fastening the fixing base 5 to the substrate 2. The fastening portion 52 of the fixing base 5 is fixed to the substrate 2 by a screw 8. The fixing base 5 is formed in a substantially rectangular parallelepiped shape having a depth of 20 mm, a width of 20 mm, and a height of 8 mm. As a material of the fixing base 5, for example, aluminum surface-treated with matte black alumite can be used. As shown in FIGS. 4 and 5, a through hole 5a and a groove 5b are formed in the fixing base 5. The through hole 5a penetrates the main body 51 of the fixing base 5 in the Z direction, and extends perpendicularly to the substrate 2. The groove 5b is formed on the bottom surface of the main body 51 of the fixing base 5 and extends over the entire length of the fixing base 5 in the X direction. As shown in FIGS. 4 and 5, the width in the X direction and the height in the Z direction of the groove 5b are larger than the diameter of the optical fiber F10.

As shown in FIG. 5, the fixing base 5 has openings 5b1, 5b2 of the groove 5b. A part of the optical fiber F10 is introduced into the groove 5b through the openings 5b1, 5b2 and is accommodated inside the fixing base 5. The first opening 5b1 is closed by the first fixing member 3, and the second opening 5b2 is closed by the second fixing member 4. A part of the first fixing member 3 enters the groove 5b through the first opening 5b1 and is located inside the fixing base 5. A part of the second fixing member 4 enters the groove 5b through the second opening 5b2 and is located inside the fixing base 5.

As shown in FIG. 5, the photodetection element 6 is formed with a cylindrical portion 6a and a flange portion 6b. The cylindrical portion 6a extends in the Z direction, and the flange portion 6b extends in a plane orthogonal to the Z direction. When the cylindrical portion 6a is fitted in the through hole 5a of the fixing base 5, the positions of the photodetection element 6 in the X and Y directions with respect to the fixing base 5 are determined. Further, in a state where the lower surface of the flange portion 6b is in contact with the upper surface of the fixing base 5, the photodetection element 6 is fixed to the fixing base 5 by the screw 7. Thereby, the position of the photodetection element 6 in the Z direction with respect to the fixing base 5 is determined.

With the above configuration, the photodetection element 6 is fixed to the fixing base 5 in a state where the positions in the X direction, the Y direction, and the Z direction with respect to the fixing base 5 are determined. Further, since the fixing base 5 is fixed to the substrate 2 by the screws 8, the photodetection element 6 is fixed to the substrate 2 through the fixing base 5. That is, the fixing base 5 fixes the photodetection element 6 to the substrate 2. Thus, the distance L between the lower end surface (hereinafter referred to as the light receiving surface 6c) of the cylindrical portion 6a of the photodetection element 6 and the outer peripheral surface of the optical fiber F10 is determined.

The photodetection element 6 receives the scattered light (for example, Rayleigh scattered light) from the optical fiber F10 at the light receiving surface 6c, and converts the intensity of the scattered light into electric power. The electric power is amplified on an electric circuit board (not shown) and input to the control device 33. Thus, the control device 33 can monitor the power of the light guided by the optical fiber F10 in real time. For example, a PIN photodiode can be used as the photodetection element 6. In a case where a PIN photodiode is used as the photodetection element 6, the distance L from the outer peripheral surface of the optical fiber F10 to the light receiving surface 6c is about several millimeters.

The first fixing member 3 and the second fixing member 4 fix the optical fiber F10 to the substrate 2. The first fixing member 3 and the second fixing member 4 are disposed on both sides of the photodetection element 6 in the X direction. As shown in FIGS. 2 to 5, the first fixing member 3 and the second fixing member 4 are formed in a substantially quarter-sphere shape. Parts of the first fixing member 3 and the second fixing member 4 respectively enter the groove 5b of the fixing base 5.

As shown in FIG. 4, the width of the first fixing member 3 or the second fixing member 4 in the X direction is referred to as a width W1. The width of the main body 51 in the X direction is referred to as a width W2. As shown in FIGS. 2 and 4, an end face of the main body 51, having the first opening 5b1 or the second opening 5b2, is referred to as an end face 51a. The end face 51a faces in the Y direction. As shown in FIG. 4, the width W1 of the first fixing member 3 or the second fixing member 4 in the X direction (direction substantially orthogonal to the surface direction of the end face 51a) when viewed from the Y direction (longitudinal direction of the optical fiber F10) Is larger than the width W2 of the main body 51 in the X direction.

The width of the first fixing member 3 or the second fixing member 4 in the Y direction (the surface direction of the end face 51a) in the main body 51 is referred to as a width W3. In the present embodiment, the width W1 and the width W3 of the first fixing member 3 or the second fixing member 4 are larger than the width W2 of the main body 51. Thus, the contact area of the first fixing member 3 and the substrate 2 is increased, and the contact area of the second fixing member 4 and the substrate 2 is increased. Therefore, the connection strength between the first fixing member 3 and the substrate 2 increases, and the connection strength between the second fixing member 4 and the substrate 2 increases, and the optical fiber F10 can be fixed to the substrate 2 more securely.

The first fixing member 3 and the second fixing member 4 are each formed of a material having a positive linear expansion coefficient. As a material of these fixing members, for example, a silicon resin having a linear expansion coefficient of about $300 \times 10^{-6}$ [/K] can be used. The specific materials of the first fixing member 3 and the second fixing member 4 may be the same as or different from each other.

As shown in FIGS. 2 to 5, the space where the light receiving surface 6c of the photodetection element 6 and the optical fiber F10 face each other is sealed by the photodetection element 6, the fixing base 5, the first fixing member 3, and the second fixing member 4. More specifically, the first fixing member 3 and the second fixing member 4 close the openings 5b1, 5b2 of the groove 5b formed in the fixing base 5.

With this configuration, it is possible to prevent dust or the like from entering the space where the light receiving surface 6c of the photodetection element 6 and the optical fiber F10 face each other and affecting the detection result of the scattered light by the photodetection element 6.

Further, in the present embodiment, a part of either the first fixing member 3 or the second fixing member 4 is located inside the fixing base 5. With this configuration, the effect of fixing the optical fiber F10 to the substrate 2 can be further enhanced, compared with the case where a part of either the first fixing member 3 or the second fixing member 4 is not located inside the fixing base 5. Further, it is possible to more reliably prevent dust or the like from entering the fixing base 5. Then, the detection result of the scattered light by the photodetection element 6 can be further stabilized. In addition, a part of the first fixing member 3 or the second fixing member 4 is located inside the fixing base 5.

Meanwhile, FIG. 3 shows the case where the first fixing member 3 and the second fixing member 4 are formed in such a shape that the temperature dependency of the detection result of the photodetection element 6 becomes small. Specifically, in top view, the volume $V_1$ of the portion of the first fixing member 3 on the first side (-X side) of the optical fiber F10 in the X direction and the volume $V_2$ of the portion on the second side (+ X side) are equal to each other. Similarly, in top view, the volume $V_3$ of the portion of the second fixing member 4 on the first side (-X side) of the optical fiber F10 in the X direction and the volume $V_4$ of the portion on the second side (+ X side) are equal to each other. That is, since the first fixing member 3 and the second fixing member 4 are formed such that $V_1 = V_2$ and, $V_3 = V_4$, the temperature dependency of the photodetection element 6 is small. At this time, as shown in FIG. 3, the center of gravity C3 of the first fixing member 3 and the center of gravity C4 of the second fixing member 4 are located on the optical fiber F10. A straight line connecting the centers of gravity C3, C4 in this ideal state is referred to as a center line O.

Here, since the first fixing member 3 and the second fixing member 4 are formed by curing the molten resin, for example, the first fixing member 3 and the second fixing member 4 are formed to be biased to the same side in the transverse direction.

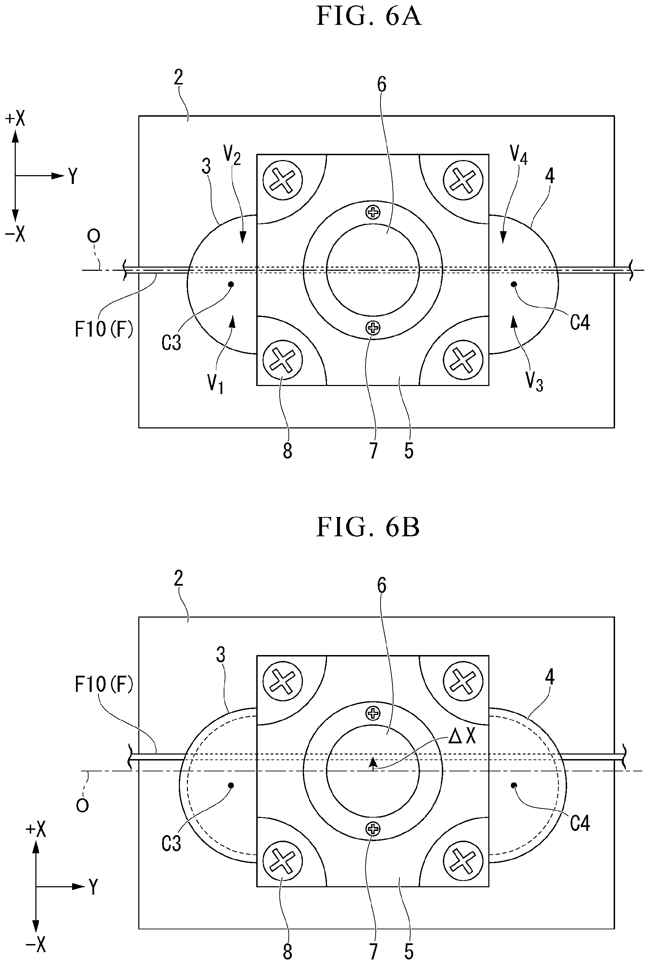

For example, as shown in FIG. 6A, the case is considered where the first fixing member 3 and the second fixing member 4 are formed at positions shifted to the -X side with respect to the optical fiber F10. In this case, $V_1 > V_2$ and $V_3 > V_4$, and the centers of gravity C3, C4 of the respective fixing members are shifted to the -X side.

FIG. 6B shows a state in which the temperature rises from the state of FIG. 6A and the first fixing member 3 and the second fixing member 4 thermally expand. The solid lines in FIG. 6B indicate the positions and shapes of the first fixing member 3, the second fixing member 4 and the optical fiber F10 after thermal expansion, and the broken lines indicate them before thermal expansion.

As shown in FIG. 6B, with the thermal expansion of the first fixing member 3 and the second fixing member 4, the optical fiber F10 moves to the + X side. This is because the first fixing member 3 and the second fixing member 4 expand around the centers of gravity C3, C4. Since the movement amount $\Delta X$ of the optical fiber F10 due to thermal expansion is proportional to temperature, the distance between optical fiber F10 and photodetection element 6 changes with temperature. Thus, the detection result of the photodetection element 6 differs according to the temperature of the photodetector 1A, resulting in temperature dependency.

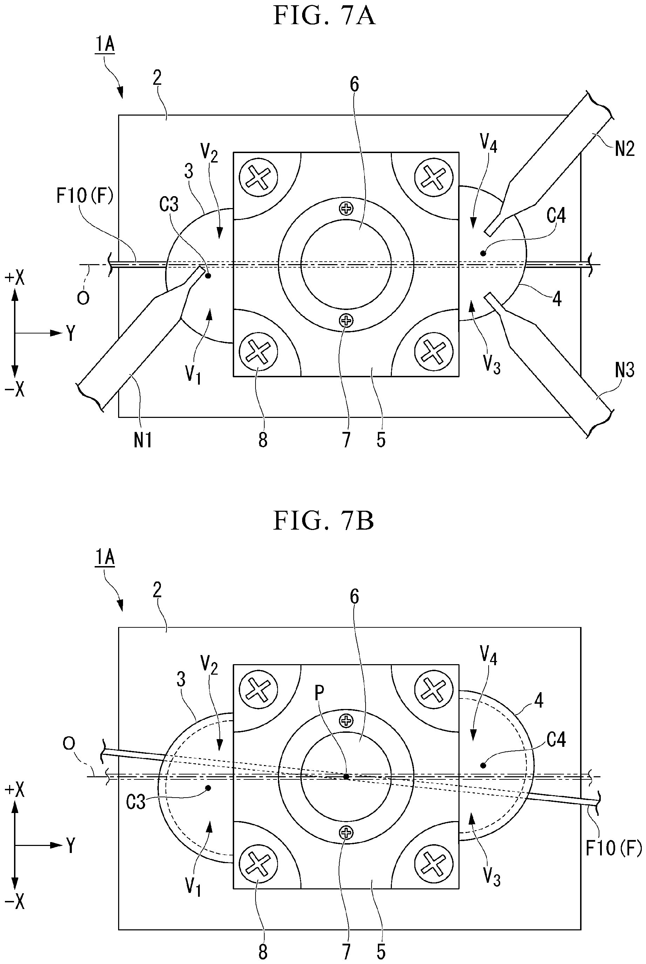

Therefore, in order to reduce the temperature dependency, the photodetector 1A of the present embodiment is formed with the first fixing member 3 and the second fixing member 4 so as to satisfy either $V_1 > V_2$ and $V_3 \leq V_4$ or $V_1 < V_2$ and $V_3 > V_4$. Hereinafter, a method of manufacturing the photodetector 1A will be described with reference to FIGS. 7A and 7B.

When manufacturing the photodetector 1A, first, the optical fiber F10 is placed on the upper surface of the substrate 2. Next, the fixing base 5 is fixed to the substrate 2 with the screw 8, in a state where the optical fiber F10 is arranged along the groove 5b of the fixing base 5. Next, the photodetection element 6 is fixed to the fixing base 5 by the screw 7.

Next, the heated and melted resin to be the first fixing member 3 is discharged from the tip of the nozzle N1 shown in FIG. 7A and applied onto the substrate 2 and the optical fiber F10. The application amount of the resin to be the first fixing member 3 is, for example, about 0.5 ml. The applied resin is cooled and solidified to form the first fixing member 3 (first application step).

Here, the tip of the nozzle N1 is disposed immediately above the optical fiber F10. The example of FIG. 7A shows a state in which the first fixing member 3 is formed to be biased to the -X side, and $V_1 > V_2$. At this time, the center of gravity C3 of the first fixing member 3 is shifted to the -X side.

Next, the volume $V_1$ of the portion on the -X side of the optical fiber F10 and the volume $V_2$ of the portion on the + X side of the formed first fixing member 3 are detected (volume detection step). The volumes $V_1$, $V_2$ can be detected, for example, by an image recognition device (not shown). In addition, in the volume detection step, the volumes $V_1$, $V_2$ may be detected before the first fixing member 3 is cured, or the volumes $V_1$, $V_2$ may be detected after the first fixing member 3 is cured.

Next, the resin to be the second fixing member 4 is respectively discharged from the plurality of nozzles N2, N3 which are separately disposed on both the +X side and the -X side of the optical fiber F10, and is applied onto the substrate 2 and the optical fiber F10 (second application step). The total amount of resin to be the second fixing member 4 discharged from the nozzles N2, N3 is, for example, about 0.5 ml. The tip portions (discharge holes) of the nozzles N2, N3 are respectively disposed at equal intervals on the + X side and the -X side from the optical fiber F10. The resin discharged from the nozzles N2, N3 merges in the vicinity of the optical fiber F10 and is cooled to form the second fixing member 4.

Here, the discharge amount of at least one of the nozzles N2, N3 is controlled based on the detection result in the volume detection step. Specifically, for example, in a case where the volume detection result is $V_1 > V_2$, it is controlled such that the discharge amount from the nozzle N2 is larger than the discharge amount from the nozzle N3. Thus, as shown in FIG. 7A, the second fixing member 4 is formed to be biased to the +X side, and $V_3 < V_4$. At this time, the center of gravity C4 of the second fixing member 4 is shifted to the +X side.

In addition, in a case where the volume detection result is $V_1 < V_2$, the discharge amounts from the nozzles N2, N3 are controlled such that $V_3 > V_4$. Further, in a case where the volume detection result is $V_1 = V_2$, the discharge amounts from the nozzles N2, N3 are controlled such that $V_3 = V_4$.

Next, the operation of the photodetector 1A manufactured in this manner will be described.

FIG. 7B shows a state in which the temperature of the photodetector 1A rises from the state of FIG. 7A and the first fixing member 3 and the second fixing member 4 thermally expand. As shown in FIG. 7B, since the first fixing member 3 expands around the center of gravity C3, the optical fiber F10 is moved toward the + X side. On the other hand, since the second fixing member 4 expands around the center of gravity C4, the optical fiber F10 is moved toward the -X side.

Thus, since the optical fiber F10 is rotated about the point P in the vicinity of the photodetection element 6, for example, as compared to the case where $V_1 > V_2$ and $V_3 > V_4$ as shown in FIG. 6A, the movement amount of the optical fiber F10 relative to the photodetection element 6 can be reduced.

In addition, the above-described operation is achieved even in the case where the photodetector 1A is configured to have $V_1 < V_2$ and $V_3 > V_4$.

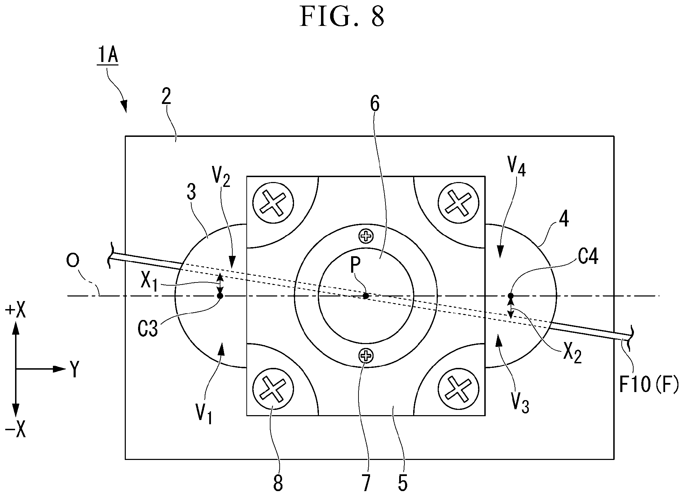

Next, as shown in FIG. 8, in a case where $V_1 > V_2$ and $V_3 < V_4$, the relationship between the optical fiber F10 with respect to the centers of gravity C3, C4 and the linear expansion coefficients of the first fixing member 3 and the second fixing member 4 is considered.

As described above, the first fixing member 3 and the second fixing member 4 expand or contract around their respective centers of gravity C3, C4 with temperature change. Here, in order to reduce the temperature dependency of the photodetection element 6, it is preferable to move the optical fiber F10 so as to rotate around a point P which is in the vicinity of the photodetection element 6. By moving in this manner, it is possible to minimize the change in the positional relationship between the optical fiber F10 and the light receiving surface 6c of the photodetection element 6.

As shown in FIG. 8, the distance in the X direction between the center of gravity C3 of the first fixing member 3 and the optical fiber F10 in the top view is $X_1$. The distance in the X direction between the center of gravity C4 of the second fixing member 4 and the optical fiber F10 in the top view is $X_2$. Further, the linear expansion coefficient of the first fixing member 3 is $\alpha_1$, and the linear expansion coefficient of the second fixing member 4 is $\alpha_2$.

Here, after there is a temperature change of $\Delta T$ from the state shown in FIG. 8, the distance in the X direction between the center of gravity C3 and the optical fiber F10 is $X_{1\Delta T}$, and the distance in the X direction between the center of gravity C4 and the optical fiber F10 is $X_{2\Delta T}$.

At this time, $X_{1\Delta T}$ and $X_{2\Delta T}$ can be expressed by the following expressions (1), (2).

$$X_{1\Delta T} = X_1 \times (\alpha_1 \times \Delta T + 1) \ldots (1)$$

$$X_{2\Delta T} = X_2 \times (\alpha_2 \times \Delta T + 1) \ldots (2)$$

The conditions for the optical fiber F10 to rotate around the point P can be represented by following expression (3).

$$X_{1\Delta T} = X_{2\Delta T} \ldots (3)$$

By substituting Expressions (1), (2) into both sides of Expression (3) and arranging, the following Expression (4) is obtained.

$$\alpha_1 / \alpha_2 = X_2 / X_1 \ldots (4)$$

By setting each condition so as to satisfy the above Expression (4), the optical fiber F10 rotates around the point P in the vicinity of the photodetection element 6. Therefore, the temperature dependency of the detection result of the scattered light can be reduced.

In addition, both the first fixing member 3 and the second fixing member 4 may be formed of a material having a positive linear expansion coefficient, and both may be formed of a material having a negative linear expansion coefficient. As a material having a negative linear expansion coefficient, for example, a synthetic resin as described in Japanese Patent No. 5699454 can be used.

In a case where both the first fixing member 3 and the second fixing member 4 are formed of a material having a negative linear expansion coefficient, for example, each fixing member expands when the temperature of the photodetector 1A rises. Therefore, it is possible to limit the bending of the optical fiber F10.

As described above, in the photodetector 1A of the present embodiment, the volumes of the first fixing member 3 and the second fixing member 4 are configured to satisfy either $V_1 > V_2$ and $V_3 \leq V_4$ or $V_1 < V_2$ and $V_3 > V_4$, the optical fiber F10 is rotationally moved relative to the photodetection element 6 with the temperature change. Thus, for example, it is configured to satisfy $V_1 > V_2$ and $V_3 > V_4$, as compared with the case where the optical fiber F10 moves in parallel with the photodetection element 6, it is possible to reduce the relative positional deviation between the optical fiber F10 and the photodetection element 6 due to the temperature change.

Further, in a case where it is configured to satisfy $\alpha_1/\alpha_2 = X_2/X_1$, the optical fiber F10 rotates around the vicinity of the photodetection element 6, it is possible to more reliably reduce the relative positional deviation between the photodetection element 6 and the optical fiber F10 due to a temperature change.

According to the manufacturing method of the photodetector 1A of the present embodiment, since the resin to be the second fixing member 4 is discharged from a plurality of nozzles N2, N3 disposed on both sides of the optical fiber F10, based on the detection results of the volumes $V_1$, $V_2$ of the first fixing member 3, for example, in a case where the first fixing member 3 is applied unevenly to the optical fiber F10 in the X direction, the second fixing member 4 is formed by controlling a discharge amount from the plurality of nozzles N2, N3 such that the relative positional deviation between the photodetection element 6 and the optical fiber F10 due to the temperature change.

Further, by controlling the discharge amount from at least one of the plurality of nozzles N2, N3 so as to satisfy either $V_1 > V_2$ and $V_3 < V_4$ or $V_1 < V_2$ and $V_3 > V_4$, the first fixing member 3 and the second fixing member 4 are formed such that the optical fiber F10 is rotationally moved with a temperature change, positional deviation between the optical fiber F10 and the photodetection element 6 due to temperature change can be more reliably reduced.

It should be noted that the technical scope of the present invention is not limited to the above-described embodiments, and various modifications can be made without departing from the spirit of the present invention.

For example, in the embodiment described above, the photodetection element 6 is fixed to the substrate 2 using the fixing base 5, but the photodetection element 6 may be fixed to the substrate 2 by another configuration without using such a fixing base 5.

Although FIG. 7 shows an example in which the discharge holes of the nozzles N2, N3 are disposed at equal intervals in the transverse direction from the optical fiber F10, the present invention is not limited to this. For example, the positions of the nozzles N2,N3 may be moved so as to satisfy either $V_1 > V_2$ and $V_3 < V_4$ or $V_1 < V_2$ and $V_3 > V_4$, by changing the positions of the discharge holes of the nozzles N2,N3.

In addition, FIG. 7 shows an example in which the resin to be the second fixing member 4 is discharged from the two nozzles N2, N3, but the present invention is not limited to this. For example, by discharging the resin to be the second fixing member 4 by one nozzle whose discharge hole is positioned on the center line O, either $V_1 > V_2$ and $V_3 < V_4$ or $V_1 < V_2$ and $V_3 > V_4$ may be satisfied. Alternatively, by discharging the resin to be the second fixing member 4 from any one of the nozzle N2 and the nozzle N3, either $V_1 > V_2$ and $V_3 < V_4$ or $V_1 < V_2$ and $V_3 > V_4$ may be satisfied.

Further, in the first embodiment, the width W1 and the width W3 are larger than the width W2, but this relationship may be different. That is, the width W1 or the width W3 may be smaller than the width W2. In this case, the area of the portion of the substrate 2 covered by the first fixing member 3 or the second fixing member 4 is reduced. Therefore, since the mounting area of the other components on the substrate 2 is increased, it is possible to realize the photodetector 1A in which the mounting density of components is improved.

Further, the main body 51 of the fixing base 5 may be formed in a plate shape having a very small width in the Y direction. In this case, the fixing base 5 may not have the groove 5b, and may be provided with only the openings 5b1, 5b2.

(Second Embodiment)

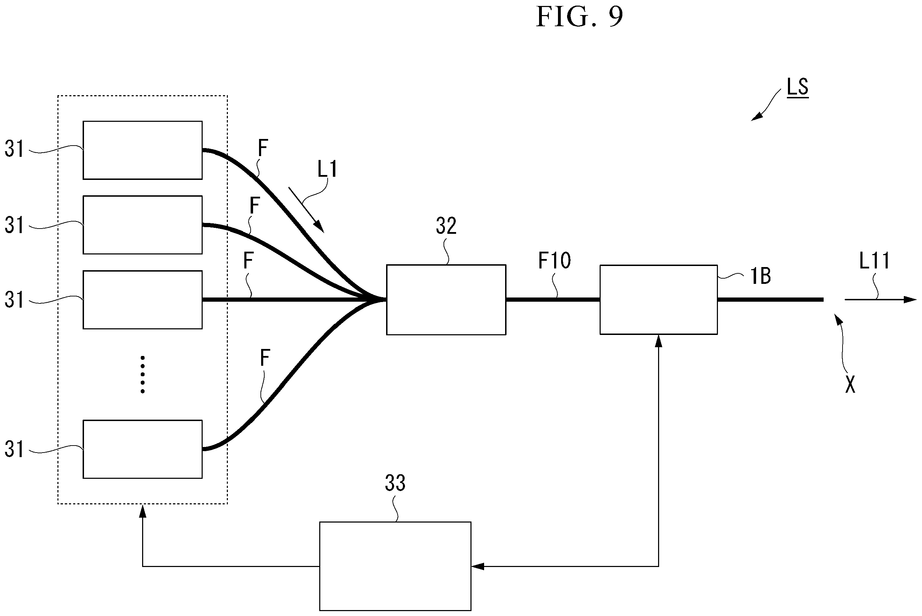

The configuration of a photodetector 1B according to the present embodiment will be described below with reference to FIGS. 9 to 13.

In order to facilitate understanding of the invention, in FIGS. 9 to 13, the scales of components are appropriately changed.

FIG. 9 is a block diagram showing the configuration of a laser system LS provided with a photodetector 1B of the present embodiment.

As shown in FIG. 9, the laser system LS includes a plurality of laser devices 31, a combiner 32 (multiplexer), an optical fiber F10 (output optical fiber), the photodetector 1B, and a control device 33 (control unit). The laser system LS outputs output light L11 (laser light) from the output end X of the optical fiber F10.

The laser device 31 is a device that outputs a laser beam under the control of the control device 33.

The combiner 32 optically combines the plurality of beams of output light L1 output from the plurality of laser devices 31. Inside the combiner 32, the optical fibers F extending from respective laser devices 31 are bundled into one (made into one by melt drawing), and the one optical fiber is fusion-spliced to one end of the optical fiber F10. The optical fiber F10 is an optical fiber functioning as a transmission medium, and guides the output light L11 (light obtained by optically combining a plurality of beams of output light L1 output from the laser devices 31 by the combiner 32). The output light L11 guided by the optical fiber F10 is output from the output end X of the optical fiber F10.

The control device 33 controls the plurality of laser devices 31 such that the power of the output light L11 output from the output end X becomes constant, based on the detection result to be described later of the photodetector 1B to be described later.

The photodetector 1B is disposed between the combiner 32 and the output end X, and detects the power of light guided by the optical fiber F10. In addition, the photodetector 1B may be disposed between the laser device 31 and the combiner 32, and may detect the power of light guided by the optical fiber F.

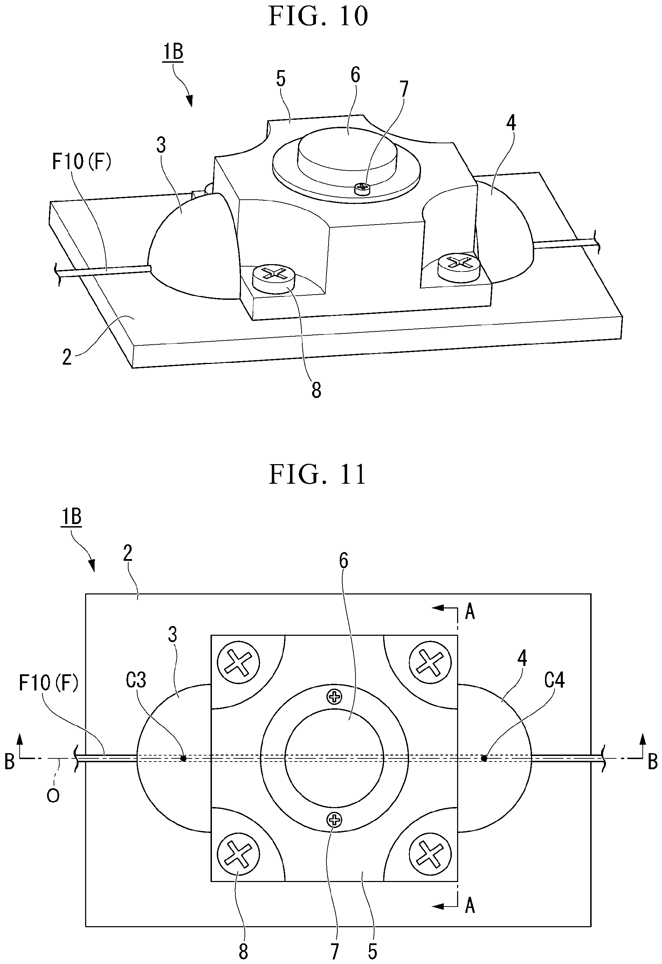

FIG. 10 is a perspective view of the photodetector 1B. As shown in FIG. 10, the photodetector 1B includes a substrate 2, an optical fiber F10 or an optical fiber F (hereinafter simply referred to as an optical fiber F10) placed on the substrate 2, a first fixing member 3, a second fixing member 4, a fixing base 5, and a photodetection element 6.

In addition, in the present embodiment, a direction in which the optical fiber F10 extends in a state before the optical fiber F10 moves due to a temperature change is referred to as a longitudinal direction. Further, a direction which is perpendicular to the surface of the substrate 2 on which the optical fiber F10 is placed is referred to as the vertical direction. The vertical direction is orthogonal to the longitudinal direction. In the vertical direction, the side of the substrate 2 on which the optical fiber F10 is placed is referred to as the upper side, and the opposite side is referred to as the lower side. Further, a direction orthogonal to the longitudinal direction and the vertical direction is referred to as the horizontal direction.

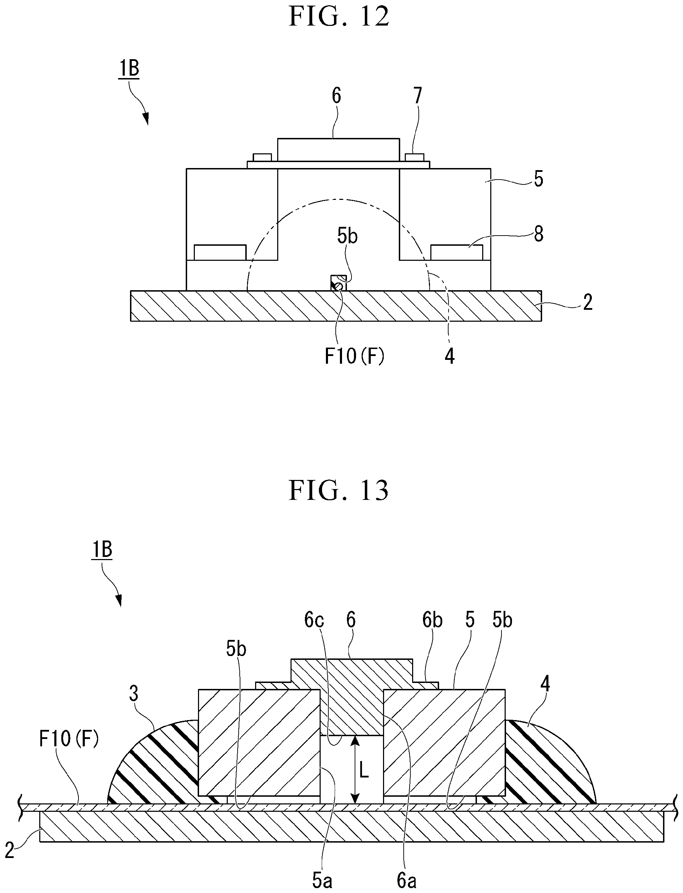

FIG. 11 is a top view of the photodetector 1B. FIG. 12 is a cross-sectional view taken along line A-A in FIG. 11, and the outline of the second fixing member 4 is indicated by a two-dot chain line. FIG. 13 is a cross-sectional view taken along line B-B in FIG. 11.

As shown in FIG. 10 and the like, the fixing base 5 is fixed to the substrate 2 by a screw 8. The fixing base 5 is formed in a rectangular parallelepiped shape having a depth of 20 mm, a width of 20 mm, and a height of 8 mm. As a material of the fixing base 5, for example, aluminum surface-treated with matte black alumite can be used. As shown in FIGS. 12 and 13, a through hole 5a and a groove 5b are formed in the fixing base 5. The through hole 5a penetrates the fixing base 5 in the vertical direction, and extends perpendicularly to the substrate 2. The groove 5b is formed on the bottom surface of the fixing base 5 and extends over the entire length of the fixing base 5 in the longitudinal direction. As shown in FIGS. 12 and 13, the width in the horizontal direction and the height in the vertical direction of the groove 5b are larger than the diameter of the optical fiber F10.

As shown in FIG. 13, the photodetection element 6 is formed with a cylindrical portion 6a and a flange portion 6b. The cylindrical portion 6a extends in the vertical direction, and the flange portion 6b extends in a plane orthogonal to the vertical direction. When the cylindrical portion 6a is fitted in the through hole 5a of the fixing base 5, the positions of the photodetection element 6 in the longitudinal direction and the horizontal direction with respect to the fixing base 5 are determined. Further, in a state where the lower surface of the flange portion 6b is in contact with the upper surface of the fixing base 5, the photodetection element 6 is fixed to the fixing base 5 by the screw 7. Thus, the position of the photodetection element 6 in the vertical direction with respect to the fixing base 5 is determined.

With the above configuration, the photodetection element 6 is fixed to the fixing base 5 in a state where the positions in the longitudinal direction, the horizontal direction, and the vertical direction with respect to the fixing base 5 are determined. Further, since the fixing base 5 is fixed to the substrate 2 by the screws 8, the photodetection element 6 is fixed to the substrate 2 through the fixing base 5. That is, the fixing base 5 fixes the photodetection element 6 to the substrate 2. Thus, the distance L between the lower end surface (hereinafter referred to as the light receiving surface 6c) of the cylindrical portion 6a of the photodetection element 6 and the outer peripheral surface of the optical fiber F10 is determined.

The photodetection element 6 receives the scattered light (for example, Rayleigh scattered light) from the optical fiber F10 at the light receiving surface 6c, and converts the intensity of the scattered light into electric power. The electric power is amplified on an electric circuit board (not shown) and input to the control device 33. Thus, the control device 33 can monitor the power of the light guided by the optical fiber F10 in real time. For example, a PIN photodiode can be used as the photodetection element 6. In a case where a PIN photodiode is used as the photodetection element 6, the distance L from the outer peripheral surface of the optical fiber F10 to the light receiving surface 6c is about several millimeters.

The first fixing member 3 and the second fixing member 4 fix the optical fiber F10 to the substrate 2. The first fixing member 3 and the second fixing member 4 are disposed on both sides of the photodetection element 6 in the longitudinal direction. As shown in FIGS. 10 to 13, the first fixing member 3 and the second fixing member 4 are each formed in a substantially quarter-sphere shape. Parts of the first fixing member 3 and the second fixing member 4 respectively enter the groove 5b of the fixing base 5.

The first fixing member 3 is formed of a material having a positive linear expansion coefficient. As a material of the first fixing member 3, for example, a silicon resin having a linear expansion coefficient of about $300 \times 10^{-6}$ [/K] can be used.

The second fixing member 4 is formed of a material having a negative linear expansion coefficient (for example, the material described in Japanese Patent No. 5699454).

In addition, the second fixing member 4 in the present embodiment is formed of a material having a negative linear expansion coefficient in the longitudinal direction. Further, the second fixing member 4 in the present embodiment is formed of a material whose absolute value of the linear expansion coefficient is larger than the absolute value of the linear expansion coefficient of the material forming the first fixing member 3.

In addition, the materials of the first fixing member 3 and the second fixing member 4 described above are only an example, and other materials may be used as long as they have a positive linear expansion coefficient and a negative linear expansion coefficient, respectively.

In addition, as shown in FIGS. 10 to 13, the space where the light receiving surface 6c of the photodetection element 6 and the optical fiber F10 face each other is sealed by the photodetection element 6, the fixing base 5, the first fixing member 3, and the second fixing member 4. More specifically, the first fixing member 3 and the second fixing member 4 close the opening of the groove 5b formed in the fixing base 5.

With this configuration, it is possible to prevent dust or the like from entering the space where the light receiving surface 6c of the photodetection element 6 and the optical fiber F10 face each other and affecting the detection result of the scattered light by the photodetection element 6.

When assembling the photodetector 1B, first, the optical fiber F10 is placed on the upper surface of the substrate 2. Next, the fixing base 5 is fixed to the substrate 2 with the screw 8, in a state where the optical fiber F10 is arranged along the groove 5b of the fixing base 5. Next, the photodetection element 6 is fixed to the fixing base 5 by the screw 7. Next, the first fixing member 3 and the second fixing member 4 which are heated and melted are applied in the vicinity of both ends of the groove 5b of the fixing base 5 in the longitudinal direction. The application amounts of the first fixing member 3 and the second fixing member 4 are, for example, about 0.5 ml, respectively. Thus, the first fixing member 3 and the second fixing member 4 are formed in a substantially quarter-sphere shape with a radius of about 6 mm, and a portion of the first fixing member 3 and the second fixing member 4 enters the groove 5b. When the first fixing member 3 and the second fixing member 4 are cooled and solidified, the optical fiber F10 is fixed to the substrate 2 by the first fixing member 3 and the second fixing member 4.

Next, the operation of the photodetector 1B configured as described above will be described in comparison with the photodetector 100 of the comparative example.

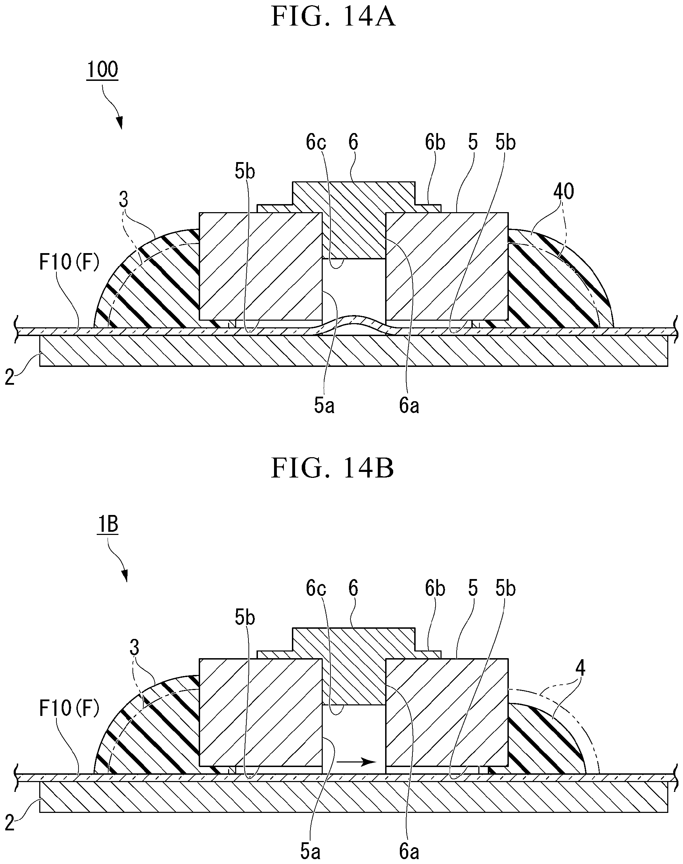

The photodetector 100 of Comparative Example includes a fixing member 40 formed of the same material as the first fixing member 3 instead of the second fixing member 4 in the photodetector 1B, as shown in FIG. 14A.

FIG. 14A is a view showing a state in which the temperature of the photodetector 100 of Comparative Example rises, and the shapes of the first fixing member 3 and the fixing member 40 before deformation due to the temperature rise is shown by a two-dot chain line.

Since the first fixing member 3 and the fixing member 40 are formed of a material having a positive linear expansion coefficient, it expand as the temperature rises, as shown in FIG. 14A. Therefore, in the optical fiber F10, all the portions fixed by the first fixing member 3 and the fixing member 40 move in the longitudinal direction toward the photodetection element 6. Thus, as shown in FIG. 14A, a part of the optical fibers F10 facing the photodetection element 6 may bend. Further, the deflection is not limited to the vertical direction, but may occur in the horizontal direction. In these cases, the distance between the optical fiber F10 and the light receiving surface 6c of the photodetection element 6 changes. Thus, the detection result of the scattered light by the photodetection element 6 changes.

In addition, in a case where the temperature falls, the first fixing member 3 and the fixing member 40 both contract. Theremore, the temperature-dependent tension acts on the portion of the optical fiber F10 facing the photodetection element 6 in the vertical direction. The tension may affect the detection result of the scattered light by the photodetection element 6.

As described above, in the photodetector 100 of the comparative example, temperature dependency occurs in the detection result of the scattered light by the photodetection element 6.

On the other hand, in the photodetector 1B of the present embodiment, the above-described temperature dependency can be reduced.

FIG. 14B is a view showing a state in which the temperature of the photodetector 1B of FIG. 13 rises, and the shapes of the first fixing member 3 and the second fixing member 4 before deformation due to the temperature rise is shown by a two-dot chain line.

Since the first fixing member 3 is formed of a material having a positive linear expansion coefficient, it expand as the temperature rises, as shown in FIG. 14B. On the other hand, since the second fixing member 4 is formed of a material having a negative linear expansion coefficient, the second fixing member 4 contracts as the temperature rises, as shown in FIG. 14B. Thus, even if the portion of the optical fiber F10 fixed by the first fixing member 3 moves in the longitudinal direction toward the photodetection element 6 side due to expansion of the first fixing member 3, the second fixing member 4 contracts to absorb the movement in the longitudinal direction, and can prevent the optical fiber F10 from bending. That is, in a case where the temperature rises, the portion of the optical fiber F10 facing the photodetection element 6 in the vertical direction is moved from the first fixing member 3 side to the second fixing member 4 side, in the direction of the arrow shown in FIG. 14B. Thus, the bending of the optical fiber F10 can be limited.

Further, in a case where the temperature falls, the first fixing member 3 contracts and the second fixing member 4 expands, the portion of the optical fiber F10 facing the photodetection element 6 in the vertical direction is moved from the second fixing member 4 side to the first fixing member 3 side, in the longitudinal direction. Thus, the bending of the optical fiber F10 can be limited.

Here, a case is considered where the position of the optical fiber F10 is fixed by being shifted from the ideal position in design. FIG. 11 shows the case where the optical fiber F10 is at an ideal position in design. The ideal position in design is a position along a center line O connecting the center of gravity (hereinafter referred to as the center of gravity C3) of the first fixing member 3 and the center of gravity of the second fixing member 4 (hereinafter referred to as the center of gravity C4).

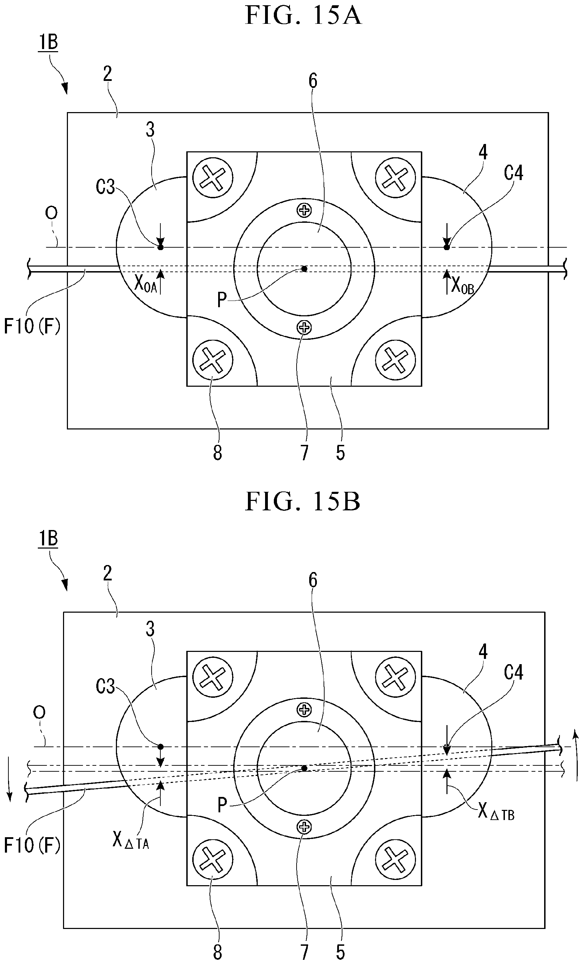

On the other hand, in the state shown in FIG. 15A, the position of the optical fiber F10 is shifted from the center line O. More specifically, the optical fiber F10 deviates from the center of gravity C3 by $X_{0A}$, and deviates from the center of gravity C4 by $X_{0B}$.

As shown in FIG. 15A, when the optical fiber F10 is fixed at a position shifted from the center line O, in a case where the temperature rises, the position of the optical fiber F10 changes as shown in FIG. 15B. Specifically, as the first fixing member 3 expands, the portion of the optical fiber F10 fixed to the first fixing member 3 moves in the horizontal direction so as to be away from the center of gravity C3. Then, as the second fixing member 4 contracts, the portion of the optical fiber F10 fixed to the second fixing member 4 moves in the left-right direction so as to approach the center of gravity C4. Due to this change in position, the positional relationship between the light receiving surface 6c of the photodetection element 6 and the optical fiber F10 may change, and a temperature dependency may occur in the detection result of the scattered light. Therefore, conditions for reducing this temperature dependency are examined.

In order to reduce the temperature dependency as described above, it is preferable to move the optical fiber F10 so as to rotate in a plane orthogonal to the vertical direction around the point P which is in the vicinity of the photodetection element 6. By moving in the horizontal direction in this manner, it is possible to minimize the change in the positional relationship between the optical fiber F10 and the light receiving surface 6c of the photodetection element 6. The condition for rotating the optical fiber F10 in the plane orthogonal to the vertical direction about the point P is that the movement amount of the optical fiber F10 in the horizontal direction due to the temperature change is equal in the portion fixed to the first fixing member 3 and the portion fixed to the second fixing member 4.

As shown in FIG. 15B, the movement amount of the portion of the optical fiber F10 fixed to the first fixing member 3 in the horizontal direction is $X_{\Delta TA}$, and the movement amount of the portion fixed to the second fixing member 4 in the horizontal direction is $X_{\Delta TB}$. The linear expansion coefficient of the material forming the first fixing member 3 is $\alpha_A$, and the absolute value of the linear expansion coefficient of the material forming the second fixing member 4 is $\alpha_B$. Further, the amount of change in temperature from the state shown in FIG. 15A is $\Delta T$. At this time, $X_{\Delta TA}$ and $X_{\Delta TB}$ can be expressed by the following expressions (5), (6).

$$X_{\Delta TA} = X_{0A} \times \alpha_A \times \Delta T \ \dots \ (5)$$

$$X_{\Delta TB} = X_{0B} \times \alpha_B \times \Delta T \ \dots \ (6)$$

The conditions for the optical fiber F10 to rotate in a plane orthogonal to the vertical direction around the point P can be represented by following Expression (7).

$$X_{\Delta TA} = X_{\Delta TB} \ \dots \ (7)$$

By substituting Expressions (5), (6) into both sides of Expression (7) and arranging, the following Expression (8) is obtained.

$$\alpha_A/\alpha_B = X_{0B}/X_{0A} \ldots (8)$$

By setting each condition so as to satisfy the above Expression (8), even when the temperature change occurs in the photodetector 1B, the optical fiber F10 rotates clockwise or counterclockwise in the plane orthogonal to the vertical direction around the point P while further keeping the relative positions of the photodetection element 6 and the optical fiber F10 in the horizontal direction. Thus, it is possible to further reduce the relative positional deviation between the photodetection element 6 and the optical fiber F10 in the horizontal direction caused by the temperature change. Therefore, the temperature dependency of the detection result of the scattered light can be reduced.

In addition, without being limited to the case where both sides have the same value as in the above Expression (8), even if the value of $\alpha_A/\alpha_B$ and the value of $X_{0B}/X_{0A}$ are substantially the same, the temperature dependency of the detection result of the scattered light described above can be reduced. Substantially same refers to, for example, the case where Expression (9) is satisfied.

$$X_{0B}/X_{0A}\times99/100 \le \alpha_A/\alpha_B \le X_{0B}/X_{0A}\times101/100 \ldots (9)$$

Expression (9) shows the case where an error between the value of $\alpha_A/\alpha_B$ and the value of $X_{0B}/X_{0A}$ is within a range of $\pm1\%$.

In addition, even in a case where the optical fiber F10 and the center line O overlap, that is, $X_{0A} = 0$ and $X_{0B} = 0$, it is possible to prevent the relative positions of the optical fiber F10 and the photodetection element 6 from changing with the temperature change as described above.

As described above, according to the photodetector 1B of the present embodiment, the optical fiber F10 is fixed to the substrate 2 by the first fixing member 3 and the second fixing member 4. Further, the first fixing member 3 is formed of a material having a positive linear expansion coefficient, and the second fixing member 4 is formed of a material having a negative linear expansion coefficient. Therefore, in a case where a temperature change occurs in the first fixing member 3 and the second fixing member 4, one of the first fixing member 3 and the second fixing member 4 contracts, and the other expands. Then, the first fixing member 3 and the second fixing member 4 are disposed on both sides of the photodetection element 6 in the longitudinal direction. Thus, in a case where a temperature change occurs in the photodetector 1B, while maintaining the relative positional relationship between the photodetection element 6 and the optical fiber F10, the optical fiber F10 rotates clockwise or counterclockwise with respect to this position. Thus, the relative positional deviation between the photodetection element 6 and the optical fiber F10 in the horizontal direction is reduced, and for example, it is possible to limit the relative positional deviation between the optical fiber F10 and the photodetection element6 in the horizontal direction caused by expansion of both the first fixing member 3 and the second fixing member 4. Further, the contraction of both the first fixing member 3 and the second fixing member 4 can limit the application of tension to the optical fiber F10.

Further, since the second fixing member 4 is formed of a material having a negative linear expansion coefficient in the longitudinal direction, when the first fixing member 3 expands in the longitudinal direction as the temperature rises, the second fixing member 4 contracts in the longitudinal direction. Thus, the expansion of both the first fixing member 3 and the second fixing member 4 in the longitudinal direction can more reliably limit the floating of the optical fiber F10 with respect to the substrate.

Further, the first fixing member 3 contracts in the longitudinal direction as the temperature falls, and the temperature change causes the second fixing member 4 to expand in the longitudinal direction. Thus, the contraction of both the first fixing member 3 and the second fixing member 4 in the longitudinal direction can limit the application of tension to the optical fiber F10.

Further, since the absolute value of the linear expansion coefficient of the material forming the second fixing member 4 is larger than the absolute value of the linear expansion coefficient of the material forming the first fixing member 3, when the temperature of the photodetector 1B rises, the amount of contraction of the volume of the second fixing member 4 exceeds the amount of expansion of the volume of the first fixing member 3. Mainly in the vertical direction or the horizontal direction, this makes it possible to more reliably limit the bending of the optical fiber F10 with respect to the substrate between the first fixing member 3 and the second fixing member 4. Further, this makes it possible to more reliably limit the change in the position of the optical fiber F10 with respect to the photodetection element 6.

Further, in a case where the photodetector 1B is configured so as to satisfy $\alpha_A/\alpha_B = X_{0B}/X_{0A}$, even if the optical fiber F10 is shifted from the ideal design position, the optical fiber F10 is moved to rotate in a plane orthogonal to the vertical direction around a point P in the vicinity of the photodetection element 6 with temperature change. Therefore, the amount of change of distance in the horizontal direction with respect to the photodetection element 6 of the optical fiber F10 according to temperature can be reduced. Thus, the temperature dependency of the detection result by the photodetection element 6 can be reduced.

It should be noted that the technical scope of the present invention is not limited to the above-described embodiments, and various modifications can be made without departing from the spirit of the present invention.

For example, in the second embodiment, the photodetection element 6 is fixed to the substrate 2 using the fixing base 5, but the photodetection element 6 may be fixed to the substrate 2 by another configuration without using such a fixing base 5.

Further, in the second embodiment, the first fixing member 3 and the second fixing member 4 are disposed to straddle the optical fiber F10 in the lateral direction, but the present invention is not limited to this. For example, the tip portions in the horizontal direction of the first fixing member 3 and the second fixing member 4 may be disposed so as to be in contact with the side surface of the optical fiber F10.

Further, the configuration described in the first embodiment may be applied to the second embodiment. For example, the fixing base 5 of the photodetector 1B may have at least one opening, and a part of the optical fiber may be accommodated inside the fixing base 5 through the opening. Further, the opening may be closed by either the first fixing member 3 or the second fixing member 4. Further, a part of either first fixing member 3 or the second fixing member 4 may be located inside the fixing base 5 (inside the groove 5b). Alternatively, the first fixing member 3 or the second fixing member 4 may not be located inside the fixing base 5. Alternatively, the opening may not be closed by the first fixing member 3 or the second fixing member 4.

Further, the photodetector 1B is configured such that either $V_1 > V_2$ and $V_3 < V_4$ or $V_1 < V_2$ and $V_3 > V_4$ is satisfied. Further, the photodetector 1B may satisfy $\alpha_1/\alpha_2 = X_2/X_1$.

(Third Embodiment)

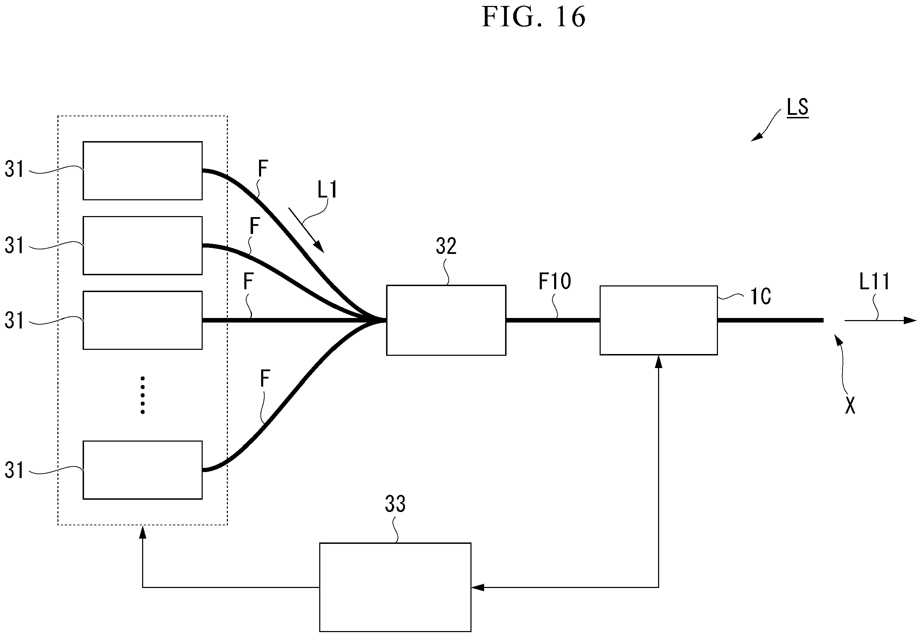

The configuration of a photodetector 1C according to the present embodiment will be described below with reference to FIGS. 16 to 21.

In addition, in order to facilitate understanding of the invention, in the drawings, the scales of components are appropriately changed.

FIG. 16 is a block diagram showing the configuration of a laser system LS provided with the photodetector 1C of the present embodiment. As shown in FIG. 16, the laser system LS includes a plurality of laser devices 31, a combiner 32 (multiplexer), an optical fiber F10 (output optical fiber), the photodetector 1C, and a control device 33 (control unit). The laser system LS outputs output light L11 (laser light) from the output end X of the optical fiber F10.

The laser device 31 is a device that outputs a laser beam under the control of the control device 33.

The combiner 32 optically combines the plurality of beams of output light L1 output from the plurality of laser devices 31. Inside the combiner 32, the optical fibers F extending from respective laser devices 31 are bundled into one (made into one by melt drawing), and the one optical fiber is fusion-spliced to one end of the optical fiber F10. The optical fiber F10 is an optical fiber functioning as a transmission medium, and guides the output light L11 (light obtained by optically combining a plurality of beams of output light L1 output from the laser devices 31 by the combiner 32). The output light L11 guided by the optical fiber F10 is output from the output end X of the optical fiber F10.

The control device 33 controls the plurality of laser devices 31 such that the power of the output light L11 output from the output end X becomes constant, based on the detection result to be described later of the photodetector 1C to be described later.

The photodetector 1C is disposed between the combiner 32 and the output end X, and detects the power of light guided by the optical fiber F10. In addition, the photodetector 1C may be disposed between the laser device 31 and the combiner 32, and may detect the power of light guided by the optical fiber F.

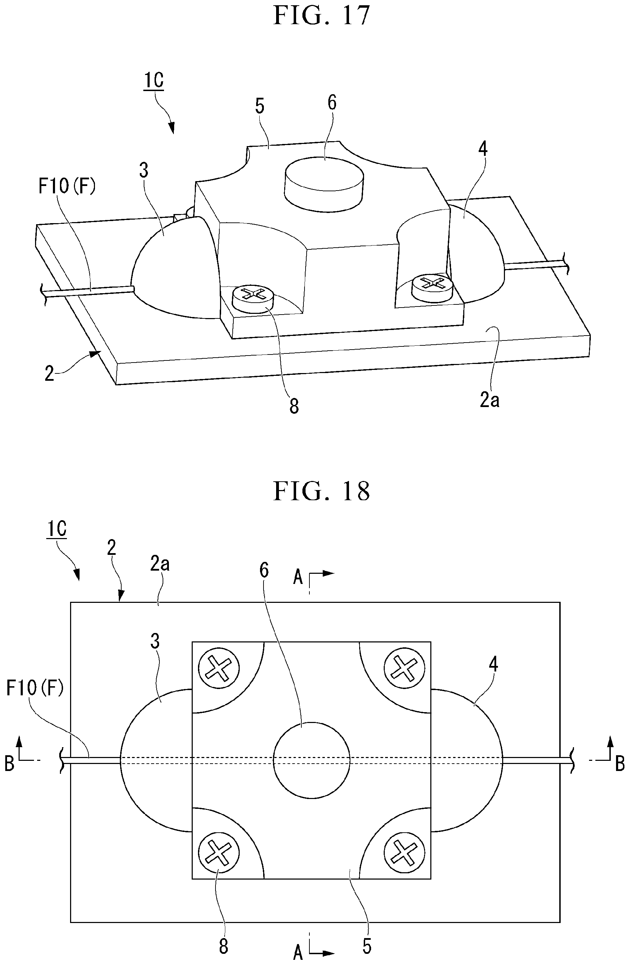

FIG. 17 is a perspective view of the photodetector 1C according to the present embodiment. As shown in FIG. 17, the photodetector 1C includes a substrate 2, a first fixing member 3, a second fixing member 4, a fixing base (element fixing base) 5, and a photodetection element 6.

The photodetector 1C is located on the mounting surface 2a of the substrate 2 and detects the scattered light of light guided by an optical fiber F10 or an optical fiber F (hereinafter simply referred to as an optical fiber F10) partially placed on the mounting surface 2a.

In addition, in the present embodiment, a direction in which the optical fiber F10 extends in a state before the optical fiber F10 moves due to a temperature change is referred to as a longitudinal direction. Further, the direction perpendicular to the mounting surface 2a of the substrate 2 is referred to as the vertical direction. The vertical direction is orthogonal to the longitudinal direction. In the vertical direction, the mounting surface 2a side of the substrate 2 is referred to as the upper side, and the opposite side is referred to as the lower side. Further, a direction orthogonal to the longitudinal direction and the vertical direction is referred to as the horizontal direction.

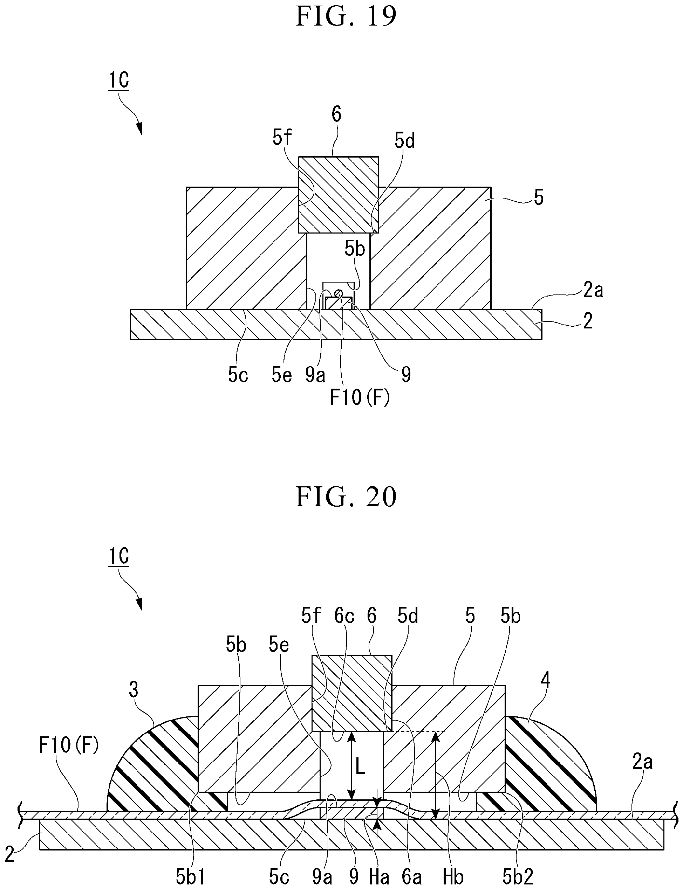

A detailed configuration of the photodetector 1C will be described below with reference to FIGS. 17 to 20. FIG. 18 is a top view of the photodetector 1C as viewed from above. FIG. 19 is a cross-sectional view taken along line A-A in FIG. 18. FIG. 20 is a cross-sectional view taken along line B-B in FIG. 18.

(Fixing Base)

The fixing base 5 fixes the photodetection element 6 to the substrate 2. The fixing base 5 is configured to expand and contract at least in the vertical direction with temperature change. A vertically extending through hole is formed in a central portion of the fixing base 5 in a top view (plan view). As shown in FIGS. 19 and 20, the through holes extend perpendicularly to the mounting surface 2a of the substrate 2. The through hole has a fitting portion 5f extending downward from the upper surface of the fixing base 5 and a reduced diameter portion 5e located below the fitting portion 5f. The fitting portion 5f and the reduced diameter portion 5e are coaxially disposed. The inner diameter of the fitting portion 5f is larger than the inner diameter of the reduced diameter portion 5e. The lower end (hereinafter referred to as a positioning portion 5d) of the fitting portion 5f is formed in an annular shape facing upward. The positioning portion 5d is located at the central portion in the vertical direction of the fixing base 5. The position of the photodetection element 6 in the vertical direction with respect to the mounting surface 2a of the substrate 2 is determined by the positioning portion 5d.

The lower surface (hereinafter referred to as the contact surface 5c) of the fixing base 5 is in contact with the mounting surface 2a of the substrate 2. Further, as shown in FIG. 17 and the like, the fixing base 5 is fixed to the substrate 2 by a screw 8. Thus, the contact surface 5c of the fixing base 5 is fixed in contact with the mounting surface 2a of the substrate 2.

As shown in FIGS. 19 and 20, the contact surface 5c of the fixing base 5 is formed with a groove 5b that is recessed upward. The groove 5b is disposed at the central portion in the horizontal direction of the fixing base 5 and partially intersects the reduced diameter portion 5e. The groove 5b extends over the entire length of the fixing base 5 in the longitudinal direction. The width in the horizontal direction and the height in the vertical direction of the groove 5b are larger than the diameter of the optical fiber F10.

As shown in FIG. 20, the fixing base 5 has openings 5b1, 5b2 of the groove 5b. A part of the optical fiber F10 is introduced into the groove 5b through the openings 5b1, 5b2 and is accommodated inside the fixing base 5. The first opening 5b1 is closed by the first fixing member 3, and the second opening 5b2 is closed by the second fixing member 4. A part of the first fixing member 3 enters the groove 5b through the first opening 5b1 and is located inside the fixing base 5. A part of the second fixing member 4 enters the groove 5b through the second opening 5b2 and is located inside the fixing base 5. A part of the optical fiber F10 is accommodated inside the groove 5b. In addition, the groove 5b of the fixing base 5 described above may be formed with a very small width in the longitudinal direction of the optical fiber F10. In this case, the fixing base 5 may not have the groove 5b, and may be provided with only the openings 5b1, 5b2.

(Photodetection Element)

The photodetection element 6 receives the scattered light (for example, Rayleigh scattered light) from the optical fiber F10 at the bottom surface (hereinafter referred to as the light receiving surface 6c), and converts the intensity of the scattered light into electric power. The electric power is amplified on an electric circuit board (not shown) and input to the control device 33 (see FIG. 16). Thus, the control device 33 can monitor the power of the light guided by the optical fiber F10 in real time. For example, a PIN photodiode can be used as the photodetection element 6. In a case where a PIN photodiode is used as the photodetection element 6, the distance from the outer peripheral surface of the optical fiber F10 to the light receiving surface 6c is about several millimeters.

The photodetection element 6 is formed in a cylindrical shape as shown in FIGS. 17 and 18. As shown in FIGS. 19 and 20, when the outer peripheral surface of the photodetection element 6 is fitted in the fitting portion 5f of the fixing base 5, the positions of the photodetection element 6 in the longitudinal direction and the horizontal direction with respect to the fixing base 5 are determined.

In addition, when the bottom surface (hereinafter referred to as the light receiving surface 6c) of the photodetection element 6 abuts on the positioning portion 5d of the fixing base 5, the position of the photodetection element 6 in the vertical direction with respect to the fixing base 5 is determined.

With the above configuration, the photodetection element 6 is fixed to the fixing base 5 in a state where the positions in the longitudinal direction, the horizontal direction, and the vertical direction with respect to the fixing base 5 are determined. Further, since the fixing base 5 is fixed to the substrate 2 by the screws 8, the photodetection element 6 is fixed to the substrate 2 through the fixing base 5. That is, the fixing base 5 fixes the photodetection element 6 to the substrate 2. In addition, since the contact surface 5c of the fixing base 5 is fixed in contact with the mounting surface 2a of the substrate 2, the distance between the mounting surface 2a of the substrate 2 and the light receiving surface 6c of the photodetection element 6 in the vertical direction is determined by the length in the vertical direction from the contact surface 5c to the positioning portion 5d (hereinafter referred to as a light receiving surface height $H_b$).

The first fixing member 3 and the second fixing member 4 fix the optical fiber F10 to the substrate 2. The first fixing member 3 and the second fixing member 4 are disposed on both sides of the photodetection element 6 in the longitudinal direction. As shown in FIGS. 17 to 20, the first fixing member 3 and the second fixing member 4 are each formed in a substantially quarter-sphere shape. Parts of the first fixing member 3 and the second fixing member 4 respectively enter the groove 5b of the fixing base 5.

(Connection Member)

Here, as shown in FIGS. 19 and 20, the photodetector 1C of the present embodiment is provided with the connection member 9 fixed in contact with the mounting surface 2a of the substrate 2. The connection member 9 has a placing surface 9a on which the optical fiber F10 is placed. The connection member 9 connects the optical fiber F10 located on the placing surface 9a and the mounting surface 2a of the substrate 2. The connection member 9 is disposed at a portion that avoids the space between the mounting surface 2a of the substrate 2 and the contact surface 5c of the fixing base 5. In the shown example, the connection member 9 is disposed in a space defined by the inner wall of the reduced diameter portion 5e of the fixing base 5 and the mounting surface 2a of the substrate 2. Thus, the placing surface 9a of the connection member 9 is disposed at a portion facing at least the light receiving surface 6c of the photodetection element 6 with the optical fiber F10 interposed therebetween in the vertical direction. In addition, for example, when the connection member 9 enters the groove 5b of the fixing base 5, the connection member 9 may not partially face the light receiving surface 6c.

The portion of the optical fiber F10 facing the photodetection element 6 is placed on the placing surface 9a, and the other portion of the optical fiber F10 is placed on the mounting surface 2a of the substrate 2. In this state, by fixing the optical fiber F10 to the substrate 2 by the first fixing member 3 and the second fixing member 4, the distance (hereinafter, simply referred to as a distance L) in the vertical direction between the light receiving surface 6c of the photodetection element 6 and the outer peripheral surface of the optical fiber F10 is determined.

In addition, the portions on both sides in the longitudinal direction of the portion of the optical fiber F10 facing the photodetection element 6 are fixed to the substrate 2 by the first fixing member 3 and the second fixing member 4. Thus, for example, the optical fiber F10 is prevented from floating from the placing surface 9a and the distance L is prevented from fluctuating.

The connection member 9 may be made of, for example, a plate-like resin, and may be bonded to the mounting surface 2a of the substrate 2 by an adhesive or the like. Alternatively, the connection member 9 may be directly formed on the mounting surface 2a, by applying a UV curable resin or a thermosetting resin to be the connection member 9 on the mounting surface 2a to have a predetermined thickness (hereinafter referred to as a connection member thickness $H_a$).

The manufacturing process of the photodetector 1C is, for example, as follows. First, a UV curable resin or thermosetting resin to be the connection member 9 is applied onto the mounting surface 2a of the substrate 2 and cured by UV light irradiation or heating. Next, the optical fiber F10 is placed on the placing surface 9a of the connection member 9. Next, the fixing base 5 to which the photodetection element 6 is attached in advance is covered from above the optical fiber F10 and the connection member 9. At this time, a part of the optical fiber F10 is accommodated in the groove 5b of the fixing base 5. Next, the fixing base 5 is fixed to the substrate 2 by the screws 8. Then, a UV curable resin or the like to be the first fixing member 3 and the second fixing member 4 is applied onto the optical fiber F10 and cured, and the optical fiber F10 is fixed to the substrate 2.

Next, the operation of the photodetector 1C configured as described above will be described.

As described above, the photodetection element 6 is fixed to the substrate 2 through the fixing base 5, and is fixed in a state where the contact surface 5c of the fixing base 5 is in contact with the mounting surface 2a of the substrate 2. Therefore, when the temperature of the photodetector 1C rises, the fixing base 5 thermally expands, and the photodetection element 6 moves upward with respect to the mounting surface 2a of the substrate 2.

On the other hand, the connection member 9 is disposed on the mounting surface 2a of the substrate 2, and the optical fiber F10 is placed on the placing surface 9a of the connection member 9. Portions of the optical fiber F10 positioned on both sides of the connection member 9 in the longitudinal direction are fixed on the mounting surface 2a of the substrate 2 by the first fixing member 3 and the second fixing member 4. The mounting surface 2a is located below the placing surface 9a. With this configuration, the portion of the optical fiber F10 placed on the placing surface 9a is pressed toward the placing surface 9a. Therefore, when the connection member 9 expands and contracts in the vertical direction, the portion of the optical fiber F10 placed on the placing surface 9a moves in the vertical direction in accordance with the expansion and contraction.

Further, the placing surface 9a is disposed at a portion facing at least the photodetection element 6 with the optical fiber F10 interposed therebetween in the vertical direction. Therefore, when the temperature of the photodetector 1C rises, the connection member 9 thermally expands, and the portion of the optical fiber F10 facing the photodetection element 6 moves upward with respect to the mounting surface 2a of the substrate 2.

As described above, in the photodetector 1C of the present embodiment, both the fixing base 5 and the connection member 9 thermally expand as the temperature rises, and both the photodetection element 6 and the optical fiber F10 are moved upward to the mounting surface 2a of the substrate 2.

Here, the connection member 9 is configured to expand and contract at least in the vertical direction with the temperature change such that the distance L is within a predetermined range (for example, the change amount of the distance L due to the temperature change is within ± 1%). In addition, preferably, the connection member 9 expands and contracts at least in the vertical direction with the temperature change such that the distance L is maintained within the above-described predetermined range. Thus, as compared with, for example, the case where the optical fiber F10 is directly placed on the mounting surface 2a of the substrate 2, it is possible to limit the relative positional deviation between the photodetection element 6 and the optical fiber F10 in the vertical direction caused by the temperature change. Therefore, it is also possible to limit the change in the detection result of the scattered light caused by the temperature change of the fixing base 5.

In addition, with respect to a specific value within the above-described predetermined range, the user sets and determines a desired value, but it may be a value determined by the user in advance, specifically, as long as the relative positional deviation between the photodetection element 6 and the optical fiber F10 in the vertical direction can be limited.

In addition, when the temperature of the photodetector 1C falls, both the connection member 9 and the fixing base 5 thermally contract. Therefore, both the photodetection element 6 and the optical fiber F10 are moved downward to the mounting surface 2a of the substrate 2. Thus, as in the case where the temperature rises, it is possible to limit the relative positional deviation between the photodetection element 6 and the optical fiber F10 in the vertical direction caused by the temperature change.

Next, conditions for achieving the above-described effect by the photodetector 1C of the present embodiment more reliably will be described.

First, a case where there is no connection member 9, and a portion of the optical fiber F10 facing the light receiving surface 6c of the photodetection element 6 faces the photodetection element 6 in a state of being directly placed on the mounting surface 2a of the substrate 2 will be considered. Here, the above-described light receiving surface height $H_b$ at the temperature $T_0$ is represented as $H_{b0}$. Further, the linear expansion coefficient of the material forming the fixing base 5 is $\alpha_b$.

When the temperature rises or fall from $T_0$ by $\Delta T$, the fixing base 5 thermally expands or thermally contracts, so the photodetection element 6 moves in the vertical direction with respect to the mounting surface 2a of the substrate 2. The movement amount of the photodetection element 6 in the vertical direction at this time is calculated by $|\Delta T \times \alpha_b \times H_{b0}|$. On the other hand, since the optical fiber F10 is directly placed on the mounting surface 2a, the distance L fluctuates by the amount of movement of the photodetection element 6 in the vertical direction. That is, the fluctuation amount of the distance L in a case where the connection member 9 is not provided (hereinafter simply referred to as "the fluctuation amount $\Delta L_r$ of the comparative example") is expressed by the following Expression (10).

$$\Delta L_r = \left| \Delta T \times \alpha_b \times H_{b0} \right| \ \dots (10)$$

On the other hand, as in the present embodiment, a case where a portion of the optical fiber F10 facing the light receiving surface 6c of the photodetection element 6 is placed on the connection member 9 will be considered. Here, the linear expansion coefficient of the material forming the connection member 9 is $\alpha_a$, and the thickness in the vertical direction at the temperature $T_0$ of the portion of the connection member 9 on which the optical fiber F10 is placed is $H_{a0}$.

When the temperature rises or fall from $T_0$ by $\Delta T$, the fixing base 5 thermally expands or thermally contracts, so the photodetection element 6 moves in the vertical direction with respect to the mounting surface 2a of the substrate 2. On the other hand, the portion of the optical fiber F10 facing the photodetection element 6 is placed on the connection member 9, and the connection member 9 also thermally expands or thermally contracts, so the optical fiber F10 also moves in the vertical direction with respect to the mounting surface 2a. The movement amount of the optical fiber F10 in the vertical direction at this time is calculated by $|\Delta T \times \alpha_a \times H_{a0}|$.

From the above, in a case where the connection member 9 is provided as in the present embodiment, the fluctuation amount of the distance L (hereinafter simply referred to as "the fluctuation amount $\Delta L_e$ of the present embodiment") is a difference between the movement amount of the photodetection element 6 in the vertical direction and the movement amount of the optical fiber F10, and is expressed by the following Expression (11).

$$\Delta L_e = \left| \Delta T \times \alpha_b \times H_{b0} - \Delta T \times \alpha_a \times H_{a0} \right| \ \dots (11)$$

In addition, examples of a condition for satisfying Expression (11) include that the photodetection element 6 and the optical fiber F10 move in the same direction due to temperature change, but in this respect, the linear expansion coefficient $\alpha_b$ of the fixing base 5 and the linear expansion coefficient $\alpha_a$ of the connection member 9 may be both positive or both negative. That is, any one of $\alpha_b > 0$ and $\alpha_a > 0$, or $\alpha_b < 0$ and $\alpha_a < 0$ may be used.

As compared with the configuration in which the connection member 9 is not provided, the condition for limiting the fluctuation of the distance L in the configuration in which the connection member 9 is provided as the present embodiment is that $\Delta L_e < \Delta L_r$. By substituting Expressions (10), (11) into both sides, the following Expression (12) is obtained.

$$\left| \Delta T \times \alpha_b \times H_{b0} - \Delta T \times \alpha_a \times H_{a0} \right| < \left| \Delta T \times \alpha_b \times H_{b0} \right| \dots (12)$$

The following Expression (12A) is obtained by excluding $\Delta T$ from both sides of Expression (12).

$$\left| \alpha_b \times H_{b0} - \alpha_a \times H_{a0} \right| < \left| \alpha_b \times H_{b0} \right| \dots (12A)$$

The following Expression (12B) is obtained by squaring the both sides of Expression (12A).

$$(\alpha_b \times H_{b0} - \alpha_a \times H_{a0})^2 < (\alpha_b \times H_{b0})^2 \dots (12B)$$

The following Expression (12C) is obtained by arranging Expression (12B).

$$\alpha_a \times H_{a0}(\alpha_a \times H_{a0} - 2 \times \alpha_b \times H_{b0}) < 0 \dots (12C)$$

For example, in a case where the material of the connection member 9 has a positive linear expansion coefficient (that is, in a case where $\alpha_a$ is a positive value), $\alpha_a \times H_{a0}$ is a positive value, so $\alpha_a \times H_{a0} - 2 \times \alpha_b \times H_{b0}$ may be a negative value in order to satisfy Expression (12C). The case where $\alpha_a \times H_{a0} - 2 \times \alpha_b \times H_{b0}$ is a negative value means a case where the amount of thermal expansion or thermal contraction of the connection member 9 does not excessively exceed the amount of thermal expansion or thermal contraction of the fixing base 5. That is, the provision of the connection member 9 means that the relative positional deviation caused by the temperature change of the photodetection element 6 and the optical fiber F10 does not increase.

Similarly, in a case where the material of the connection member 9 has a negative linear expansion coefficient, $\alpha_a \times H_{a0} - 2 \times \alpha_b \times H_{b0}$ may be a positive value in order to satisfy the condition of Expression (12C). Similarly to the above conditions, this condition also means that the relative positional deviation caused by the temperature change of the photodetection element 6 and the optical fiber F10 does not increase by providing the connection member 9.

From the above, since the connection member 9 and the fixing base 5 are configured to satisfy Expression (12C), the thermal expansion amount or thermal contraction amount of the connection member 9 excessively exceeds the thermal expansion amount or thermal contraction amount of the fixing base 5, and it is possible to limit an increase in relative positional deviation caused by the temperature change of the photodetection element 6 and optical fiber F10 more reliably by providing the connection member 9. Therefore, it is possible to limit more reliably the change in the detection result of the scattered light caused by the temperature change of the fixing base 5.

Next, the optimum conditions for limiting the fluctuation of the distance L caused by the temperature change will be considered.

In the present embodiment, the fluctuation amount $\Delta L_e$ is expressed by Expression (11). The condition for this to be 0 is obtained by solving the following Expression (11A).

$$\left| \Delta T \times \alpha_b \times H_{b0} - \Delta T \times \alpha_a \times H_{a0} \right| = 0 \dots (11A)$$

When both sides of the above Expression (11A) are divided by $\Delta T$ and arranged, the following conditional expression (13) is obtained.

$$\alpha_b \times H_{b0} = \alpha_a \times H_{a0} \dots (13)$$

By designing the connection member 9 and the fixing base 5 so as to satisfy the above Expression (13), the fluctuation of the distance L due to the temperature change becomes zero.

Meanwhile, both sides of the above Expression (13) do not need to have completely the same value, and if the

value of $\alpha_b \times H_{b0}$ and the value of $\alpha_a \times H_{a0}$ are substantially the same, the amount of movement of the photodetection element 6 in the vertical direction with respect to the mounting surface 2a of the substrate 2 due to thermal expansion or thermal contraction of the fixing base 5 and the amount of movement of the optical fiber F10 in the vertical direction with respect to the mounting surface 2a of the substrate 2 due to thermal expansion or thermal contraction of the connection member 9 are substantially the same. Thus, even if a temperature change occurs, the photodetection element 6 and the optical fiber F10 are displaced while maintaining the relative positional relationship in the vertical direction, and it is possible to further limit the relative positional deviation in the vertical direction of the both caused by the temperature change. Therefore, it is possible to further limit the change in the detection result of the scattered light caused by the temperature change of the fixing base 5.

In addition, example of a case where the value of $\alpha_b \times H_{b0}$ and the value of $\alpha_a \times H_{a0}$ are substantially the same include a case where the following Expression (14) is satisfied.

$$\alpha_b \times H_{b0} \times 99/100 \le \alpha_a \times H_{a0} \le \alpha_b \times H_{b0} \times 101/100 \ldots (14)$$

The above Expression (14) shows the case where an error between the value of $\alpha_b \times H_{b0}$ and the value of $\alpha_a \times H_{a0}$ is within $\pm 1\%$. Since the connection member 9 is configured to expand and contract in the vertical direction so as to satisfy the above Expression (14), the fluctuation amount of the distance L due to the temperature change can be set within $\pm 1\%$ and can be kept.

Next, a specific example of the photodetector 1C of the present embodiment will be described.

In this example, the photodetector 1C is mounted so as to detect the laser power in the optical fiber F10 of 125 $\mu$m located most downstream of the high-power laser system LS as shown in FIG. 16. As the photodetection element 6, a photo detector (PD) in which the current value fluctuates according to the amount of received light is used. In this example, as a material of the fixing base 5, aluminum surface-treated with matte black alumite is used. The linear expansion coefficient of this aluminum is $23 \times 10^{-6}$ [/K]. The dimensions of the fixing base 5 are 20 mm in the longitudinal direction, 20 mm in the horizontal direction, and 60 mm in the vertical direction, and are formed in a rectangular parallelepiped shape as a whole.

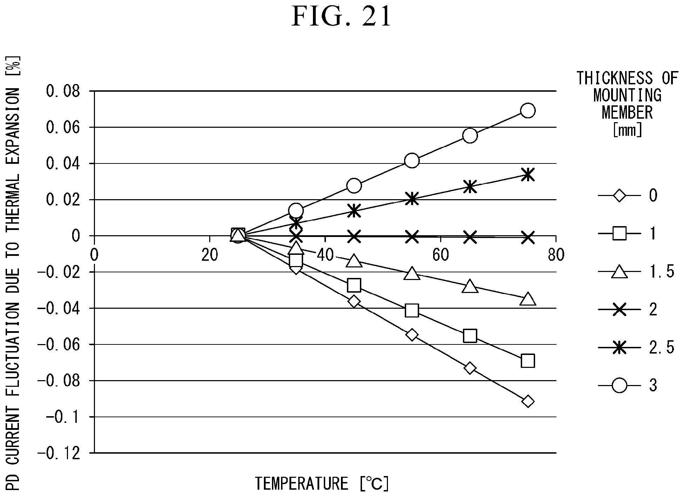

A resin having a linear expansion coefficient of $69 \times 10^{-6}$ [/K] is used as the material of the connection member 9 of the present embodiment. With respect to a plurality of photodetectors 1C in which the thickness of the connection member 9 in the vertical direction is changed in the range of 0 to 3 mm, a laser of constant power is guided to the optical fiber F10, and the fluctuation of the current value of PD (hereinafter referred to as PD current fluctuation) in a case where the temperature of the photodetector 1C is changed from normal temperature (25 °C) to 80 °C is shown in FIG. 21. The case where the thickness of the connection member 9 in the vertical direction is 0 mm indicates the case where the optical fiber F10 is directly placed on the mounting surface 2a of the substrate 2 without providing the connection member 9.

The vertical axis of the graph shown in FIG. 21 is the PD current fluctuation [%] with reference to the state at normal temperature (25 °C), and the horizontal axis is the temperature [°C] of the photodetector 1C.

As shown in FIG. 21, in a case where the connection member 9 is not provided (in a case where the thickness of the connection member 9 is 0 mm), when the temperature of the photodetector 1C rises to 60 °C, there is a PD current fluctuation of about -0.06%. Since the power of the laser guided to the optical fiber F10 is constant, this means that the PD current fluctuation is caused by the fluctuation of the distance L shown in FIG. 16, and the accuracy of the power detection result is lowered according to the temperature change.

On the other hand, in a case where the connection member 9 is provided as in the present embodiment, the value of the PD current fluctuation is limited to a small value as compared with the case where the connection member 9 is not provided. Specifically, in a case where the thickness of the connection member 9 in the vertical direction is 1 mm, the PD current fluctuation at 60 °C is about -0.05%.

Further, in a case where the thickness of the connection member 9 in the vertical direction is 3 mm, the PD current fluctuation at 60 °C is about +0.05%. Thus, in the present embodiment, in order to limit the PD current fluctuation at 60 °C within $\pm$ 0.05%, it is found that the thickness of the connection member 9 in the vertical direction may be set within a range of 1 to 3 mm.

Further, as shown in FIG. 21, in the present example, by setting the thickness of the connection member 9 in the vertical direction to 2 mm, it is possible to substantially eliminate the PD current fluctuation according to the temperature. This indicates that in a case where the thickness of the connection member 9 in the vertical direction is 2 mm, both sides of the above Expression (13) have substantially the same value.

It should be noted that the technical scope of the present invention is not limited to the above-described first to third embodiments, and various modifications can be made without departing from the spirit of the present invention.

For example, in the third embodiment, the portion of the optical fiber F10 facing the photodetection element 6 in the vertical direction is placed on the placing surface 9a of the connection member 9, and the other portion is placed on the mounting surface 2a of the substrate 2, but the present invention is not limited to this. For example, the placing surface 9a of the connection member 9 may extend over the entire length of the substrate 2 in the longitudinal direction, and the optical fiber F10 may be placed over the entire length of the placing surface 9a.

In addition, a part of the configuration described in the first embodiment may be applied to the third embodiment. For example, the fixing base 5 of the photodetector 1C may have at least one opening, and a part of the optical fiber may be accommodated inside the fixing base 5 through the opening. Further, the opening may be closed by either the first fixing member 3 or the second fixing member 4. Further, a part of either the first fixing member 3 or the second fixing member 4 may be located inside the fixing base 5 (inside the groove 5b). Alternatively, the first fixing member 3 or the second fixing member 4 may not be located inside the fixing base 5. Alternatively, the opening may not be closed by the first fixing member 3 or the second fixing member 4.

Further, the photodetector 1C is configured such that either $V_1 > V_2$ and $V_3 < V_4$ or $V_1 < V_2$ and $V_3 > V_4$ is satisfied. Further, the photodetector 1C may satisfy $\alpha_1/\alpha_2 = X_2/X_1$.

Further, the configuration described in the second embodiment may be applied to the third embodiment. For example, the first fixing member 3 of the photodetector 1C may be formed of a material having a positive linear expansion coefficient, and the second fixing member 4 may be formed of a material having a negative linear expansion coefficient.

In addition, without departing from the spirit of the present invention, it is possible to appropriately replace the constituent elements in the above-described embodiment with well-known constituent elements, and the above-described embodiment and modifications may be appropriately combined.

For example, by combining the first embodiment with a part of the contents described in the second embodiment, the first fixing member 3 of the photodetector 1A may be formed of a material having a positive linear expansion coefficient, and the second fixing member 4 may be formed of a material having a negative linear expansion coefficient.

Alternatively, by combining the first embodiment with a part of the contents described in the third embodiment, the photodetector 1A may be fixed to the substrate 2 in contact with the mounting surface 2a of the substrate 2, and may include the connection member 9 having a placing surface 9a on which the optical fiber is placed, and connecting the optical fiber positioned on the placing surface 9a and the substrate 2. Further, the fixing base 5 of the photodetector 1A may have a contact surface 5c fixed in contact with the mounting surface 2a, and the contact surface 5c may be disposed in a portion facing the photodetection element 6 with at least the optical fiber interposed therebetween. Further, the connection member 9 may expand and contract at least in the vertical direction with the temperature change such that the distance in the vertical direction between the optical fiber placed on the placing surface 9a and the photodetection element 6 is within a predetermined range.

Similarly, a part of the contents described in the first or third embodiment may be combined with the second embodiment.

Similarly, a part of the contents described in the first or second embodiment may be combined with the third embodiment.

Reference Signs List

| | |
|---|---|
| 1A to 1C | photodetector |
| 2 | substrate |
| 2a | mounting surface |
| 3 | first fixing member |
| 4 | second fixing member |
| 5 | fixing base |
| 5b | groove |
| 5c | contact surface |
| 5d | positioning portion |
| 51 | main body |
| 6 | photodetection element |
| 9 | connection member |
| 9a | mounting surface |
| F | optical fiber |
| F10 | optical fiber |

**Claims**

1. A photodetector comprising:

   a substrate;
   an optical fiber which is placed on the substrate; and
   a photodetection element which is fixed to the substrate, and is configured to detect scattered light of light guided by the optical fiber.

2. The photodetector according to claim 1, further comprising:

   a first fixing member and a second fixing member which fix the optical fiber to the substrate,
   wherein the first fixing member is disposed on an opposite side of the photodetection element from the second fixing member in a longitudinal direction in which the optical fiber extends,
   wherein either $V_1 > V_2$ and $V_3 < V_4$, or $V_1 < V_2$ and $V_3 > V_4$ is satisfied when a volume of a portion of the first fixing member on a first side across the optical fiber in a transverse direction orthogonal to the longitudinal direction is $V_1$ and a volume of a portion of the first fixing member on a second side opposite to the first side is $V_2$, in top view, and a volume of a portion of the second fixing member on the first side of the optical fiber in the transverse direction is $V_3$, and a volume of a portion of the second fixing member on the second side is $V_4$, in top view,.

3. The photodetector according to claim 2,
   wherein when a linear expansion coefficient of a material forming the first fixing member is $\alpha_1$, and a linear expansion coefficient of a material forming the second fixing member is $\alpha_2$, and in top view, a distance between a center of gravity of the first fixing member and the optical fiber in the transverse direction is $X_1$, and a distance between a center of gravity of the second fixing member and the optical fiber in the transverse direction is $X_2$, $\alpha_1/\alpha_2 = X_2/X_1$ is satisfied.

4. A method for manufacturing a photodetector including a substrate, an optical fiber which is placed on the substrate, a photodetection element which is fixed to the substrate, and is configured to detect scattered light of light guided by the optical fiber, and a first fixing member and a second fixing member which fix the optical fiber to the substrate, the first fixing member being disposed on an opposite side of the photodetection element from the second fixing member in a longitudinal direction in which the optical fiber extends, the method comprising:

   a first application step of applying a resin to be the first fixing member to the substrate and the optical fiber;
   a volume detection step of detecting a volume $V_1$ of a portion of the first fixing member on a first side across the optical fiber in a transverse direction orthogonal to the longitudinal direction, and a volume $V_2$ of a portion on a second side opposite to the first side, in top view; and
   a second application step of applying a resin to be the second fixing member to the substrate and the optical fiber, based on a detection result in the volume detection step,
   wherein when, in top view, a volume of a portion of the second fixing member on the first side of the optical fiber in the transverse direction is $V_3$, and a volume of a portion of the second fixing member on the second side is $V_4$, a discharge amount of the resin to be the second fixing member is controlled such that either $V_1 > V_2$ and $V_3 < V_4$, or $V_1 < V_2$ and $V_3 > V_4$ is satisfied, in the second application step.

5. The photodetector according to any one of claims 1 to 3, further comprising:

   a first fixing member and a second fixing member which fix the optical fiber to the substrate,
   wherein the first fixing member is disposed on an opposite side of the photodetection element from the second fixing member in a longitudinal direction in which the optical fiber extends, and
   wherein the first fixing member is formed of a material having a positive linear expansion coefficient, and the second fixing member is formed of a material having a negative linear expansion coefficient.

6. The photodetector according to claim 5,
   wherein the second fixing member is formed of a material having a negative linear expansion coefficient in the longitudinal direction.

7. The photodetector according to claim 5 or 6,

wherein an absolute value of the linear expansion coefficient of the material forming the second fixing member is larger than an absolute value of the linear expansion coefficient of the material forming the first fixing member.

8. The photodetector according to any one of claims 5 to 7,
wherein when the linear expansion coefficient of the material forming the first fixing member is $\alpha_A$, an absolute value of the linear expansion coefficient of the material forming the second fixing member is $\alpha_B$, a distance between a center of gravity of the first fixing member and the optical fiber is $X_{0A}$, and a distance between a center of gravity of the second fixing member and the optical fiber is $X_{0B}$, a value of $\alpha_A/\alpha_B$ and a value of $X_{0B}/X_{0A}$ are substantially the same.

9. The photodetector according to any one of claims 1 to 3 or 5 to 7, further comprising:

a first fixing member and a second fixing member which fix the optical fiber to the substrate; and
a fixing base which fixes the photodetection element to the substrate,
wherein the fixing base has at least one opening,
wherein a portion of the optical fiber is accommodated inside the fixing base through the opening, and
wherein the at least one opening is closed by either the first fixing member or the second fixing member.

10. The photodetector according to claim 9,
wherein a part of either the first fixing member or the second fixing member is located inside the fixing base.

11. The photodetector according to claim 9 or 10,
wherein the fixing base has a main body that holds the photodetection element, and
wherein a width of either the first fixing member or the second fixing member is larger than a width of the main body.

12. The photodetector according to claim 9 or 10,
wherein the fixing base has a main body that holds the photodetection element, and
wherein a width of either the first fixing member or the second fixing member is smaller than a width of the main body.

13. The photodetector according to any one of claims 1 to 3 or 5 to 12, further comprising:

a connection member which is fixed to the substrate in contact with a mounting surface of the substrate, has a placing surface on which the optical fiber is placed, and connects the optical fiber located on the placing surface and the substrate; and
a fixing base which fixes the photodetection element to the substrate, and expands and contracts at least in a vertical direction with a temperature change,
wherein the fixing base has at least one opening, and a contact surface fixed in contact with the mounting surface,
wherein a portion of the optical fiber is accommodated inside the fixing base through the opening,
wherein the placing surface is positioned at least a portion facing the photodetection element across the optical fiber, and
wherein the connection member expands and contracts at least in the vertical direction with a temperature change such that the distance in the vertical direction between the optical fiber located on the placing surface and the photodetection element is within a predetermined range.

14. The photodetector according to claim 13,
wherein the fixing base has a positioning unit which determines a position of the photodetection element in a vertical direction with respect to the mounting surface, and
wherein when a linear expansion coefficient of a material forming the connection member is $\alpha_a$, a linear expansion coefficient of a material forming the fixing base is $\alpha_b$, a thickness in the vertical direction of a portion of the connection member on which the optical fiber is placed is $H_{a0}$, and a length in the vertical direction from the contact surface to the positioning portion is $H_{b0}$, $\alpha_a \times H_{a0}(\alpha_a \times H_{a0} - 2 \times \alpha_b \times H_{b0}) < 0$ is satisfied.

15. The photodetector according to claim 14,
wherein a value of $\alpha_b \times H_{b0}$ and a value of $\alpha_a \times H_{a0}$ are substantially the same.

# FIG. 1

# FIG. 2

# FIG. 3

# FIG. 4

1A

6    7

51a

5b (5b2)

5

8

52

2

F10 (F)

4 (3)

W2

W1

Z

−X ←→ +X

# FIG. 5

1A

51a    5b    6c    6    6b    5    5b    51a

3

F10 (F)

L

4

5b1    51    5a    6a    5b2

2

W3    W3

Z

→ Y

# FIG. 6A

# FIG. 6B

# FIG. 7A

1A

2

6

$V_2$

3

$V_4$

N2

F10 (F)

C3

C4

+X

O

Y

4

−X

$V_1$

$V_3$

N3

N1

8

7

5

# FIG. 7B

1A

2

6

$V_2$

3

P

$V_4$

O

4

C4

+X

C3

Y

−X

F10 (F)

$V_1$

$V_3$

8

7

5

# FIG. 8

FIG. 9

EP 3 578 937 A1

# FIG. 10

# FIG. 11

# FIG. 12

# FIG. 13

# FIG. 14A

# FIG. 14B

# FIG. 15A

# FIG. 15B

FIG. 16

EP 3 578 937 A1

# FIG. 17

# FIG. 18

**EP 3 578 937 A1**

# FIG. 19

# FIG. 20

37

# FIG. 21

<h1 style="text-align:center">INTERNATIONAL SEARCH REPORT</h1>

| International application No. |
| --- |
| PCT/JP2018/002931 |

**A. CLASSIFICATION OF SUBJECT MATTER**
Int.Cl. G01J1/02(2006.01)i, G02B6/42(2006.01)i, H01L31/0232(2014.01)i

According to International Patent Classification (IPC) or to both national classification and IPC

**B. FIELDS SEARCHED**

Minimum documentation searched (classification system followed by classification symbols)
Int.Cl. G01J1/00-1/60, G02B6/42, H01L31/0232, H01S3/00

Documentation searched other than minimum documentation to the extent that such documents are included in the fields searched
Published examined utility model applications of Japan 1922-1996
Published unexamined utility model applications of Japan 1971-2018
Registered utility model specifications of Japan 1996-2018
Published registered utility model applications of Japan 1994-2018

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2014-60251 A (SPECTRONIX CORP.) 03 April 2014, paragraphs [0021]-[0027], [0039], fig. 2, 3 (Family: none) | 1-2, 9-13 |
| A | JP 2013-174583 A (FUJIKURA LTD.) 05 September 2013 (Family: none) | 1-15 |

☒ Further documents are listed in the continuation of Box C. ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 10.04.2018 | 24.04.2018 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

| International application No. |
| --- |
| PCT/JP2018/002931 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 2015-525342 A (IPG PHOTONICS CORPORATION) 03 September 2015 <br> & WO 2014/035505 A2 & CN 104335018 A & KR 10-2015-0020281 A | 1-15 |
| A | US 2014/0313513 A1 (LIAO) 23 October 2014 (Family: none) | 1-15 |
| A | JP 2005-43762 A (SUMITOMO ELECTRIC INDUSTRIES, LTD.) 17 February 2005 (Family: none) | 1-15 |
| A | JP 57-138191 A (KOKUSAI DENSHIN DENWA CO., LTD.) 26 August 1982 <br> & US 4523802 A & GB 2093631 A | 1-15 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017017430 A
- JP 2017017476 A
- JP 2017017477 A

- JP 2013508688 A
- JP 5699454 B